# EUROPEAN PATENT APPLICATION

(11) **EP 4 746 619 A1**
(43) Date of publication of application: **20.05.2026**
(21) Application number: 25215074.3
(22) Date of filing: 11.11.2025
(51) Int. Cl.: H10B 12/00, H10D 1/68

(54) **SEMICONDUCTOR DEVICE INCLUDING DATA STORAGE STRUCTURE**

(30) Priority: 15.11.2024 KR 20240163406; 13.12.2024 KR 20240185695
(71) Applicant: Samsung Electronics Co., Ltd., Suwon-si, Gyeonggi-do 16677 (KR)
(72) Inventor: LEE, Sunjung, 16677 Suwon-si (KR); KIM, Seokwon, 16677 Suwon-si (KR); LEE, Jungha, 16677 Suwon-si (KR); LEE, Dosun, 16677 Suwon-si (KR)
(74) Representative: Marks & Clerk LLP

(57) **Abstract**

A semiconductor device includes: transistors stacked in a vertical direction; a bit line electrically connected to a first end of each of the transistors; and a data storage structure electrically connected to a second end of each of the transistors. The data storage structure includes: conductive pillars extending in a first horizontal direction; an electrode pattern covering the conductive pillars; and a dielectric layer between each of the conductive pillars and the electrode pattern. The first horizontal direction is perpendicular to the vertical direction and is a direction oriented from the bit line to the data storage structure, each of the conductive pillars has a first side surface adjacent to a corresponding transistor among the transistors, and a second side surface opposite to the first side surface, and the second side surface of a first conductive pillar among the conductive pillars has a convex shape.

## Description

### BACKGROUND

Example embodiments relate to a semiconductor device including a data storage structure and a forming method thereof.

Research has been conducted to reduce the size of elements included in semiconductor devices and to improve performance thereof. For example, in a Dynamic Random Access Memory (DRAM), research has been conducted to reliably and stably form reduced-size elements, but with a decrease in the size of the elements, the dispersion characteristics of semiconductor devices may be deteriorated.

### SUMMARY

Example embodiments provide a semiconductor device increasing a degree of integration.

Example embodiments provide a semiconductor device improving performance.

Example embodiments provide a forming method of the semiconductor device.

According to example embodiments, the semiconductor device includes: transistors stacked in a vertical direction; a bit line electrically connected to a first end of each of the transistors; and a data storage structure electrically connected to a second end of each of the transistors. The data storage structure includes: conductive pillars extending in a first horizontal direction; an electrode pattern covering the conductive pillars; and a dielectric layer between each of the conductive pillars and the electrode pattern. The first horizontal direction is perpendicular to the vertical direction and is a direction oriented from the bit line to the data storage structure, each of the conductive pillars has a first side surface adjacent to a corresponding transistor, among the transistors, and a second side surface opposite to the first side surface, and the second side surface of a first conductive pillar, among the conductive pillars, has a convex shape.

The data storage structure may include a plurality of discrete capacitors, wherein each of the discrete capacitors includes a corresponding conductive pillar among the conductive pillars.

Each of the discrete capacitors may further include a corresponding region of the electrode pattern and a corresponding region of the dielectric layer.

According to example embodiments, a semiconductor device includes: transistors sequentially stacked in a vertical direction; a bit line electrically connected to a first end of each of the transistors; and a data storage structure electrically connected to a second end of each of the transistors. The data storage structure includes: conductive pillars each extending in a first horizontal direction and electrically connected to a respective transistor of the transistors; an electrode pattern covering the conductive pillars; and a dielectric layer between the electrode pattern and each of the conductive pillars. The first horizontal direction is perpendicular to the vertical direction and is a direction oriented from the bit line to the data storage structure, each of the conductive pillars has a first side surface adjacent to a corresponding transistor, among the transistors, and a second side surface opposite to the first side surface, and a first conductive pillar, among the conductive pillars, includes a first grain extending from a lower surface of the first conductive pillar to an upper surface of the first conductive pillar.

According to example embodiments, a semiconductor device includes: a memory structure; and a peripheral structure overlapping the memory structure in a vertical direction and including a peripheral circuit. The memory structure includes: transistors each including a first source/drain region, a channel region, and a second source/drain region sequentially stacked in the vertical direction and sequentially arranged in a first horizontal direction, perpendicular to the vertical direction; a bit line connected to the first source/drain regions of the transistors; conductive patterns each connected to the second source/drain region of a corresponding transistor of the transistors; and a data storage structure connected to the conductive patterns. Each of the conductive patterns includes: a metal-semiconductor compound region connected to the second source/drain region of the corresponding transistor; and a nitrided conductive region connected to the data storage structure.

According to example embodiments, a semiconductor device includes: transistors stacked in a vertical direction; a bit line electrically connected to a first side of each of the transistors; and a data storage structure electrically connected to a second side of each of the transistors. The data storage structure includes: conductive pillars extending in a first horizontal direction; an electrode pattern covering the conductive pillars; and a dielectric layer between the conductive pillars and the electrode pattern, the first horizontal direction is perpendicular to the vertical direction and is a direction oriented from the bit line to the data storage structure, and each of the conductive pillars includes a pillar pattern and a capping pattern sequentially arranged in the first horizontal direction.

The pillar pattern may include a first conductive material, and the capping pattern may include a second conductive material different from the first conductive material.

A maximum length of the pillar pattern in the first horizontal direction may be greater than a maximum length of the capping pattern in the first horizontal direction.

Among the pillar pattern and the capping pattern sequentially arranged in the first horizontal direction, the pillar pattern may include a first grain having a first width in the first horizontal direction, and the capping pattern may include a second grain having a second width greater than the first width in the first horizontal direction.

The capping pattern may include a first portion and a second portion extending from the first portion into the pillar pattern and surrounded by the pillar pattern, and at least a portion of the first portion of the capping pattern may not vertically overlap the pillar pattern.

The pillar pattern may include a first material layer and a second material layer, the first material layer may cover a lower surface and an upper surface of the second material layer and extends between adjacent transistors (e.g., a corresponding transistor) among the transistors and the second material layer, and the capping pattern may be in contact with the first material layer and the second material layer.

The semiconductor device may further include an insulating support pattern. The pillar pattern of each of the conductive pillars may include: a first region vertically overlapping the insulating support pattern; and a second region extending from the first region in the first horizontal direction and contacting the capping pattern. An upper surface and a lower surface of the first region may be in contact with the insulating support pattern, and an upper surface and a lower surface of the second region may be in contact with the dielectric layer.

According to example embodiments, a semiconductor device includes: a memory structure; and a peripheral structure overlapping the memory structure in a vertical direction and including a peripheral circuit. The memory structure includes: transistors respectively including a first source/drain region, a channel region, and a second source/drain region sequentially stacked in the vertical direction and arranged sequentially in a first horizontal direction, perpendicular to the vertical direction; a bit line connected to the first source/drain regions of the transistors; and a data storage structure electrically connected to the second source/drain regions of the transistors. The data storage structure includes: conductive pillars respectively electrically connected to the second source/drain regions and respectively extending in the first horizontal direction; an electrode pattern covering the conductive pillars; and a dielectric layer between the electrode pattern and the conductive pillars. Each of the conductive pillars includes a pillar pattern and a capping pattern sequentially arranged in the first horizontal direction.

The semiconductor device may further include conductive patterns disposed between the second source/drain regions and the conductive pillars. Each of the conductive patterns may include a metal-semiconductor compound.

A maximum length of the pillar pattern in the first horizontal direction may be greater than a maximum length of the capping pattern in the first horizontal direction.

According to example embodiments, a method of forming a semiconductor device includes: forming an active pattern, a gate adjacent to the active pattern, and a bit line electrically connected to a first end of the active pattern; on a second end of the active pattern opposite to the first end, forming a metal-semiconductor compound layer; nitriding an end portion of the metal-semiconductor compound layer to form a nitrided conductive region; forming a conductive pillar on the nitride conductive region using a metal growth process using a precursor including a first metal element; forming a dielectric layer over an exposed surface of the conductive pillar; and forming an electrode pattern covering the dielectric layer.

The forming of the metal-semiconductor compound layer may include reacting a second metal element with a semiconductor element of the active pattern.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings.
FIG. 1 is a conceptual perspective view illustrating a semiconductor device according to example embodiments of the present disclosure.
FIG. 2 is a conceptual perspective view illustrating an example of a semiconductor device according to an example embodiment of the present disclosure.
FIG. 3 is a conceptual perspective view illustrating an example of a semiconductor device according to an example embodiment of the present disclosure.
FIGS. 4, 5A, and 5B are views illustrating examples of semiconductor devices according to an example embodiment of the present disclosure.
FIG. 6A is a partially enlarged cross-sectional view illustrating an example of a semiconductor device according to an example embodiment of the present disclosure.
FIG. 6B is a partially enlarged cross-sectional view illustrating an example of a semiconductor device according to an example embodiment of the present disclosure.
FIGS. 7A and 7B are views illustrating an example of a semiconductor device according to an example embodiment of the present disclosure.
FIGS. 8A and 8B are views illustrating an example of a semiconductor device according to an example embodiment of the present disclosure.
FIGS. 9A and 9B are views illustrating an example of a semiconductor device according to an example embodiment of the present disclosure.
FIGS. 10A and 10B are views illustrating a semiconductor device according to an example embodiment of the present disclosure.
FIGS. 11A and 11B are views illustrating a semiconductor device according to an example embodiment of the present disclosure.
FIGS. 12A and 12B are views illustrating an example of a semiconductor device according to an example embodiment of the present disclosure.
FIG. 13A is a partially enlarged cross-sectional view illustrating an example of a semiconductor device according to an example embodiment of the present disclosure.
FIG. 13B is a partially enlarged cross-sectional view illustrating an example of a semiconductor device according to an example embodiment of the present disclosure.
FIG. 13C is a partially enlarged cross-sectional view illustrating an example of a semiconductor device according to an example embodiment of the present disclosure.
FIGS. 14A and 14B are views illustrating an example of a semiconductor device according to an example embodiment of the present disclosure.
FIGS. 15A and 15B are views illustrating an example of a semiconductor device according to an example embodiment of the present disclosure.
FIGS. 16A and 16B are views illustrating an example of a semiconductor device according to an example embodiment of the present disclosure.
FIGS. 17A and 17B are views illustrating an example of a semiconductor device according to an example embodiment of the present disclosure.
FIGS. 18 to 28 are views illustrating a forming method of a semiconductor device according to an example embodiment of the present disclosure.
FIGS. 29 to 31 are views illustrating a forming method of a semiconductor device according to an example embodiment of the present disclosure.

### DETAILED DESCRIPTION

Hereinafter, terms such as "upper," "intermediate," and "lower" may be replaced with other terms such as "first," "second," and "third" and may be used to describe elements of the specification. The terms such as "first," "second," and "third" may be used to describe various elements, but the elements are not limited thereto, and the "first element" could be termed a "second element." In the specification, terms such as 'lower portion," 'upper portion,' 'upper end' and 'lower end' may be terms described based on the drawings.

Throughout the specification, when a component is described as "including" or "comprising" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Spatially relative terms, such as "beneath," "below," "lower," "above," "upper," "top," "bottom," "front," "rear," and the like, may be used herein for ease of description to describe positional relationships, such as illustrated in the figures, for example. It will be understood that the spatially relative terms encompass different orientations of the device in addition to the orientation depicted in the figures.

An item, layer, or portion of an item or layer described as "extending" or as "extending lengthwise" in a particular direction has a length in the particular direction and a width perpendicular to that direction, where the length is greater than the width.

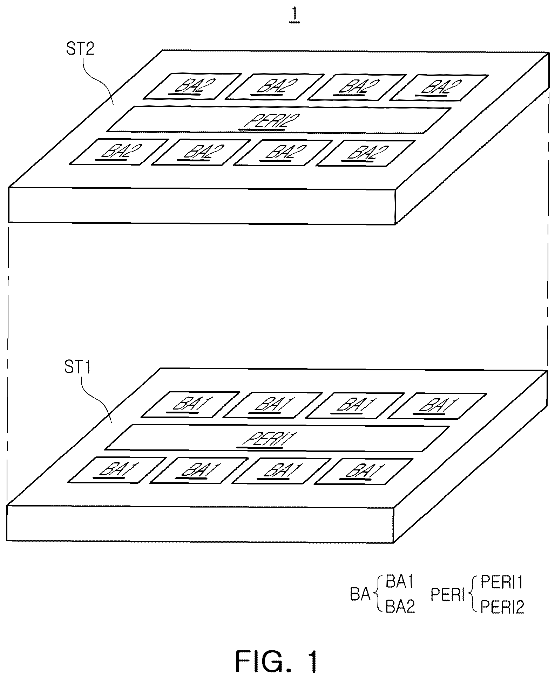

Referring to FIG. 1, a semiconductor device according to an example embodiment of the present disclosure will be described. FIG. 1 is a conceptual perspective view illustrating a semiconductor device according to an example embodiment of the present disclosure.

Referring to FIG. 1, a semiconductor device 1 according to an example embodiment may include a memory structure ST1 (e.g., a memory) and a peripheral structure ST2 vertically overlapping the memory structure ST1. The memory structure ST1 may include a memory region, and the peripheral structure ST2 may include a peripheral circuit.

The semiconductor device 1 may include a plurality of banks BA and an external peripheral region PERI.

The external peripheral region PERI may include a first peripheral region PERI1 within the memory structure ST1 and a second peripheral region PERI2 within the peripheral structure ST2. The external peripheral region PERI may be a peripheral region in which peripheral circuits for input/output of data or commands, or input of power/ground, are disposed.

Each of the above-described plurality of banks BA may include a first bank region BA1 within the memory structure ST1 and a second bank region BA2 within the peripheral structure ST2.

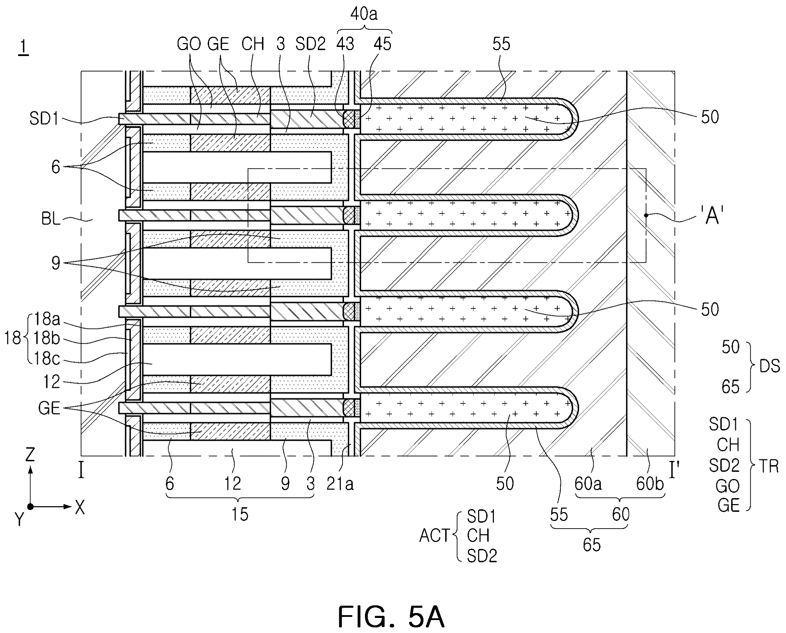

The first bank region BA1 within the memory structure ST1 may include memory cells TR, DS (see FIG. 5A). Each of the memory cells TR, DS (see FIG. 5A) may include a data storage structure DS (see FIG. 5A) (e.g., a data storage) that may serve as information storage and a transistor TR (see FIG. 5A) electrically connected to the data storage structure DS.

The second bank region BA2 within the peripheral structure ST2 may include peripheral circuits such as a sense amplifier and a sub-word line driver.

In an example embodiment, the memory structure ST1 and the peripheral structure ST2 may be formed by being bonded by a bonding process such as a wafer bonding process. Accordingly, the memory structure ST1 may be bonded (e.g., to the peripheral structure ST2) by contacting the peripheral structure ST2.

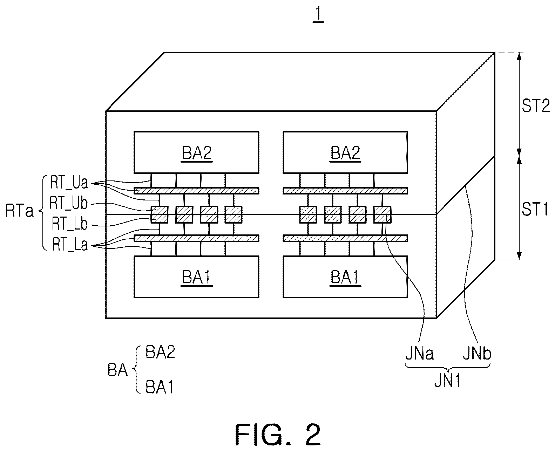

Examples of a structure in which the memory structure ST1 and the peripheral structure ST2 are bonded by the above-described bonding process will be described with reference to FIG. 2. FIG. 2 is a conceptual perspective view illustrating an example of bonding the memory structure ST1 of FIG. 1 to the peripheral structure ST2 of FIG. 1 by a wafer bonding process.

In an example embodiment, referring to FIGS. 1 and 2, the memory structure ST1 and the peripheral structure ST2 may further include a routing interconnection structure RTa electrically connecting the first bank region BA1 to the second bank region BA2. For example, the routing interconnection structure RTa may include first routing interconnection structures RT_La and RT_Lb disposed within the memory structure ST1 and second routing interconnection structures RT_Ua and RT_Ub disposed within the peripheral structure ST2.

The first routing interconnection structures RT_La and RT_Lb may include a first interconnection structure RT_La electrically connected to the first bank region BA1 and first bonding pads RT_Lb electrically connected to the first interconnection structure RT_La. The second routing interconnection structures RT_Ua and RT_Ub may include a second interconnection structure RT_Ua electrically connected to the second bank region BA2 and second bonding pads RT_Ub electrically connected to the second interconnection structure RT_Ua.

The first bonding pads RT_Lb and the second bonding pads RT_Ub may be in contact with each other and may be bonded. For example, the first bonding pads RT_Lb and the second bonding pads RT_Ub may include copper and may be bonded to each other by a metal-to-metal bonding process. Accordingly, a bonding surface JN1 between the memory structure ST1 and the peripheral structure ST2 may include metal-to-metal bonding regions JNa in which the first bonding pads RT_Lb of the memory structure ST1 and the second bonding pads RT_Ub of the peripheral structure ST2 are bonded to each other, and dielectric-to-dielectric bonding regions JNb in which a dielectric of the memory structure ST1 and a dielectric of the peripheral structure ST2 are bonded to each other.

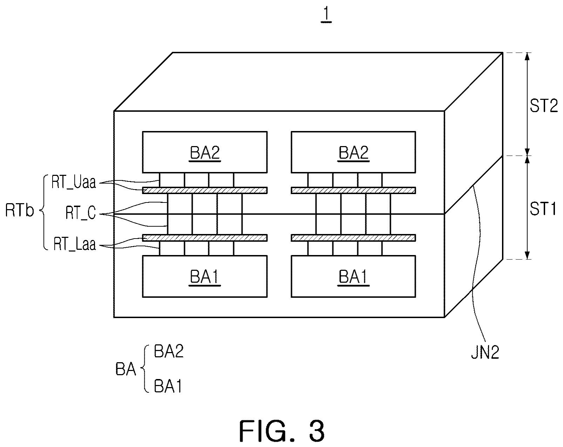

Next, a description will be provided of a modified example of the above-described routing interconnection structure RTa and the bonding surface JN1 with reference to FIG. 3. FIG. 3 is a conceptual perspective view illustrating a modified example of the above-described routing interconnection structure RTa and the bonding surface JN1 with reference to FIG. 2.

In an example embodiment, referring to FIGS. 1 and 3, the above-described routing interconnection structure RTa in FIG. 2 may be replaced with a routing interconnection structure RTb in which the first bonding pads RT_Lb (see FIG. 2) and the second bonding pads RT_Ub (see FIG. 2) may be omitted, and the above-described bonding surface JN1 (see FIG. 2) in FIG. 2 may be replaced with a bonding surface JN2 in which the metal-to-metal bonding regions JNa (see FIG. 2) may be omitted and may be formed as a dielectric-to-dielectric bonding region.

The routing interconnection structure RTb may include a first interconnection structure RT_Laa included in the memory structure ST1 and electrically connected to the first bank region BA1, a second interconnection structure RT_Uaa included in the peripheral structure ST2 and electrically connected to the second bank region BA2, and a connection structure RT_C extending from the memory structure ST1 to the peripheral structure ST2 and electrically connecting the first and second interconnection structures RT_Laa, RT_Uaa to each other.

The bonding surface JN2 between the memory structure ST1 and the peripheral structure ST2 may be formed as a dielectric bonding surface in which a dielectric of the memory structure ST1 and a dielectric of the peripheral structure ST2 are bonded to each other. The connection structure RT_C may include a through-via or a through-connection plug that may penetrate through the bonding surface JN2.

Hereinafter, examples of a region in which the memory cells TR, DS (see FIG. 5A) are disposed in the first bank region BA1 of the memory structure ST1 of the semiconductor device 1 described in FIG. 1 will be described.

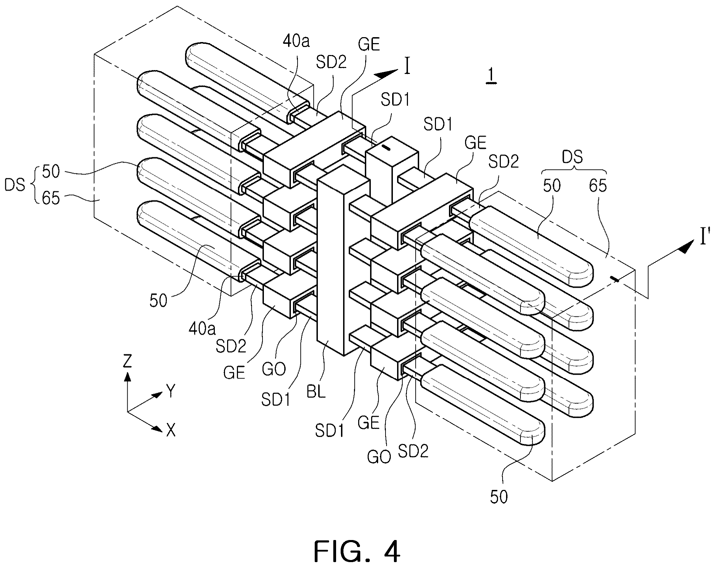

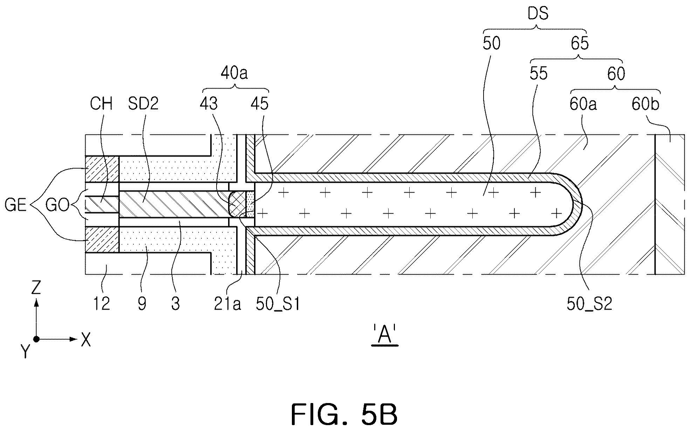

First, referring to FIG. 4, FIG. 5A, and FIG. 5B, an example of the semiconductor device 1 described above will be described. FIG. 4 is a perspective view conceptually illustrating a region in which the memory cells TR, DS (see FIG. 5A) are disposed in the first bank region BA1 (see FIG. 1) of the memory structure ST1 (see FIG. 1) in order to explain an example of the semiconductor device 1 according to an example embodiment of the present disclosure, and FIG. 5A is a cross-sectional view illustrating a region taken along line I-I' of FIG. 4, and FIG. 5B is a partially enlarged view illustrating a region indicated by 'A' of FIG. 5A.

Referring to FIG. 1, FIG. 4, FIG. 5A and FIG. 5B, the semiconductor device 1 may include bit lines BL and data storage structures DS.

Each of the bit lines BL may extend in a vertical direction (Z-direction). The bit lines BL may be disposed between adjacent data storage structures DS. The memory structure ST1 (see FIG. 1) and the peripheral structure ST2 (see FIG. 1) described in FIG. 1 may overlap each other in the vertical direction (Z-direction).

In example embodiments, a direction, perpendicular to the vertical direction (Z-direction), and directed from the bit lines BL to the data storage structures DS, may be defined as a first horizontal direction (X-direction). For example, the first horizontal direction (X-direction) may be defined as a direction oriented from one bit line BL of the bit lines BL toward one data storage structure DS of the data storage structures DS.

The bit lines BL may be spaced apart from each other in the second horizontal direction (Y-direction), which is perpendicular to the first horizontal direction (X-direction) and to the vertical direction (Z-direction).

Hereinafter, a description will be made focusing on one bit line BL of the bit lines BL and one data storage structure DS of the data storage structures DS.

The semiconductor device 1 may further include transistors TR. The transistors TR may be stacked to be spaced apart from each other in the vertical direction (Z-direction). The transistors TR may be disposed between the bit line BL and the data storage structure DS. The bit line BL may be electrically connected to a first side of each of the transistors TR (e.g., to first source/drain regions of each of the transistors TR), and the data storage structure DS may be electrically connected to a second side of each of the transistors TR (e.g., to second source/drain regions of each of the transistors TR). The transistors TR and the data storage structure DS may form memory cells TR, DS.

Each of the above transistors TR may include a first source/drain region SD1, a channel region CH, a second source/drain region SD2, a gate dielectric layer GO, and a gate electrode GE.

In each of the above transistors TR, the first source/drain region SD1, the channel region CH, and the second source/drain region SD2 may be sequentially arranged in the first horizontal direction (X-direction).

The first source/drain regions SD1 of the transistors TR may be electrically connected to the bit line BL. The second source/drain regions SD2 of the transistors TR may be electrically connected to the data storage structure DS.

In each of the transistors TR, the gate electrode GE may vertically overlap the channel region CH, and the gate dielectric layer GO may be disposed between the gate electrode GE and the channel region CH. In each of the transistors TR, the gate electrode GE may extend in the second horizontal direction (Y-direction) and in the vertical direction (Z-direction) to surround the channel region CH. For example, in the second horizontal direction (Y-direction) and the vertical direction (Z-direction), the gate electrode GE may cover a lower surface, an upper surface, and side surfaces of the channel region CH. The gate electrodes GE of the transistors TR may be word lines.

The semiconductor device 1 may include active patterns ACT stacked in the vertical direction (Z-direction) and spaced apart from each other. Each of the active patterns ACT may include the first source/drain region SD1, the channel region CH, and the second source/drain region SD2, sequentially arranged in the first horizontal direction (X-direction). For example, the first source/drain regions SD1, the channel regions CH, and the second source/drain regions SD2 may be disposed within the active patterns ACT. In each of the active patterns ACT, a maximum thickness of the second source/drain region SD2 in the vertical direction (Z-direction) may be greater than a maximum thickness of the first source/drain region SD1 in the vertical direction (Z-direction). In each of the active patterns ACT, a thickness of the channel region CH in the vertical direction (Z-direction) may be substantially the same as a thickness of the first source/drain region SD1 in the vertical direction (Z-direction).

The active patterns ACT may be disposed between the bit line BL and the data storage structure DS. The active patterns ACT may have a shape extending into the bit line BL. The first source/drain regions SD1 of the active patterns ACT may extend into the bit line BL. The active patterns ACT may be formed of a semiconductor material. For example, the active patterns ACT may be formed of a semiconductor material such as single crystal silicon.

The data storage structure DS may include conductive pillars 50 extending in the first horizontal direction (X-direction) and a pattern structure 65 covering the conductive pillars 50.

Each of the conductive pillars 50 may have a first side surface 50_S1 adjacent to (e.g., facing) a corresponding transistor among the transistors TR, and a second side surface 50_S2 opposite to the first side surface 50_S1. The second side surface 50_S2 of the first conductive pillar 50, among the conductive pillars 50, may have a convex shape. For example, the second side surface 50_S2 of the first conductive pillar 50 may have a curved shape such that, when viewed along the second horizontal direction (Y-direction), a middle portion of the second side surface 50_S2 is farther away from the corresponding transistor TR than are upper and lower portions of the second side surface 50_S2.

The pattern structure 65 may include an electrode pattern 60 covering the conductive pillars 50 and a dielectric layer 55 between the conductive pillars 50 and the electrode pattern 60. The electrode pattern 60 may cover an upper surface and a lower surface of each of the conductive pillars 50, may cover side surfaces of each of the conductive pillars 50 facing each other in the second horizontal direction (Y-direction), and may cover the second side surfaces 50_S2 of the conductive pillars 50.

The electrode pattern 60 may include a first conductive layer 60a in contact with the dielectric layer 55 and a second conductive layer 60b spaced apart from the dielectric layer 55 and in contact with the first conductive layer 60a.

The data storage structure DS may be formed of memory cell capacitors capable of storing data in a memory such as a DRAM. For example, in the data storage structure DS, each of the conductive pillars 50 may be a first electrode of a memory cell capacitor, the first conductive layer 60a of the electrode pattern 60 may be a second electrode of the memory cell capacitor, and the dielectric layer 55 may be a capacitor dielectric layer of the memory cell capacitor. The second conductive layer 60b of the electrode pattern 60 may be a plate electrode pattern. The DRAM may be formed of discrete memory cells. Each memory cell may include, for example, a transistor and one of the memory cell capacitors. The memory cell capacitors may be discrete capacitors. Each memory cell may be connected to a word line and a bit line, for example.

The semiconductor device 1 may further include conductive patterns 40a.

Each of the conductive patterns 40a may include a metal-semiconductor compound region 43 in contact with the second source/drain region SD2 of a corresponding transistor, among the transistors TR, and a nitrided conductive region 45 in contact with a corresponding conductive pillar, among the conductive pillars 50.

The metal-semiconductor compound region 43 may include a first conductive material, and the nitrided conductive region 45 may include a second conductive material formed by nitriding the first conductive material. For example, the metal-semiconductor compound region 43 may include a metal silicide, and the nitrided conductive region 45 may include a conductive material formed by nitriding the metal silicide. For example, the metal-semiconductor compound region 43 may include at least one of TiSi, MoSi, ZrSi, and CoSi, and the nitrided conductive region 45 may include a material formed by nitriding at least one of TiSi, MoSi, ZrSi, and CoSi, for example, at least one of TiSiN, MoSiN, ZrSiN, and CoSiN. The above-described nitrided conductive region 45 of the conductive material may act as a barrier preventing a metal element of the conductive pillars 50, for example, Mo or W, from diffusing into the active patterns ACT.

The semiconductor device 1 may further include a first insulating structure 15, a second insulating structure 18, and a buffer insulating layer 21a.

Between the active patterns ACT adjacent to each other in the vertical direction (Z-direction), the first insulating structure 15 may include a first insulating layer 12 disposed between the adjacent active patterns ACT in the vertical direction (Z-direction), second insulating layers 6 disposed between the gate electrodes GE and the bit line BL in the first horizontal direction (X-direction), a third insulating layer 9 disposed between the gate electrodes GE and the data storage structure DS and between the first insulating layer 12 and the data storage structure DS in the first horizontal direction (X-direction), and a fourth insulating layer 3 disposed between the gate dielectric layers GO and the data storage structure DS in the first horizontal direction (X-direction).

Each of the gate dielectric layers GO may be disposed between the gate electrode GE and the channel region CH in a corresponding active pattern ACT, among the active patterns ACT, and may extend between the second insulating layer 6 and the first source/drain region SD1 in the active pattern ACT.

Between the active patterns ACT adjacent to each other in the vertical direction (Z-direction), the second insulating structure 18 may include a fifth insulating layer 18c in contact with the bit line BL and disposed between the first insulating structure 15 and the bit line BL, a sixth insulating layer 18b disposed between the fifth insulating layer 18c and the first insulating structure 15 and covering an upper surface and a lower surface of the fifth insulating layer 18c, and a seventh insulating layer 18a disposed between the sixth insulating layer 18b and the first insulating structure 15 and covering an upper surface and a lower surface of the sixth insulating layer 18b.

The buffer insulating layer 21a may be disposed between the conductive patterns 40a adjacent to each other in the vertical direction (Z-direction), and may be disposed between the first insulating structure 15 and the data storage structure DS. The buffer insulating layer 21a may prevent leakage current between the electrode pattern 60 and the conductive patterns 40a.

The conductive pillars 50 may include a conductive material that may be formed using a metal growth process. For example, the conductive pillars 50 may include Mo or W. Each of the conductive pillars 50 may include at least one grain (e.g., crystalline grain). For example, at least one conductive pillar among the conductive pillars 50 may be formed of a single grain or a plurality of grains.

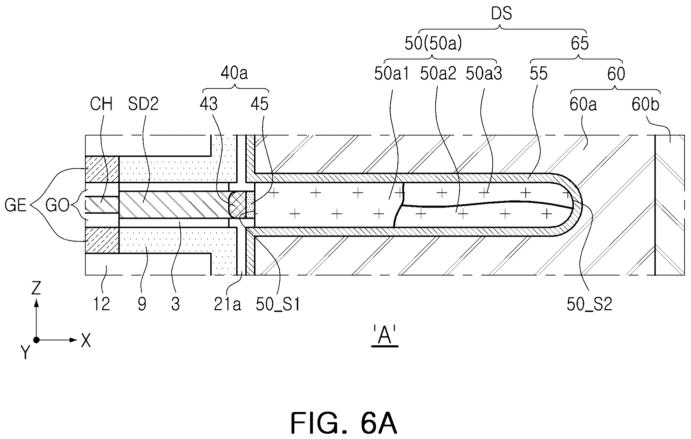

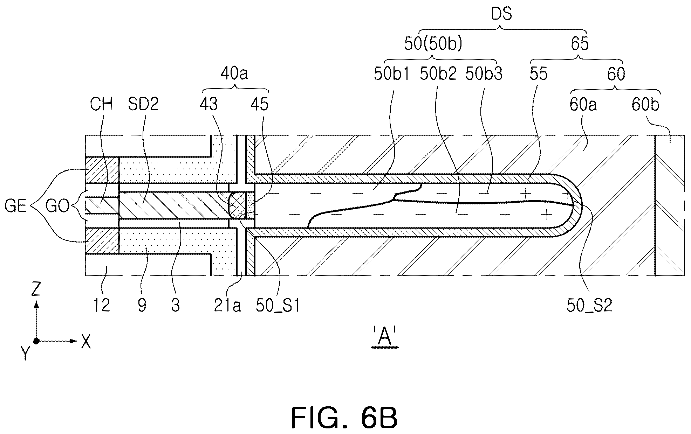

Next, an example in which at least one conductive pillar among the conductive pillars 50 is formed of the plurality of grains will be described with reference to FIGS. 6A and 6B, respectively. FIG. 6A is a partially enlarged view illustrating a region indicated by 'A' in FIG. 5A, and may illustrate an example of a conductive pillar 50a formed by the plurality of grains, and FIG. 6B is a partially enlarged view illustrating a region indicated by 'A' in FIG. 5A, and may illustrate an example of a conductive pillar 50b formed by the plurality of grains.

In an example embodiment, referring to FIGS. 5A and 6A, one (e.g., a conductive pillar 50a) of the conductive pillars 50 may include a first grain 50a1, a second grain 50a2, and a third grain 50a3.

At least one of the first to third grains 50a1, 50a2 and 50a3 may have a length (e.g., maximum length) in the first horizontal direction (X-direction), greater than a thickness (e.g., maximum thickness) of the conductive pillar 50a in the vertical direction (Z-direction).

The first grain 50a1 may extend from a lower surface of the conductive pillar 50a to an upper surface of the conductive pillar 50a. For example, the first grain 50a1 may have a length (e.g., maximum length) in the first horizontal direction (X-direction) greater than the thickness (e.g., maximum thickness) of the conductive pillar 50a in the vertical direction (Z-direction).

At least one of the second and third grains 50a2 and 50a3 may have a thickness (e.g., maximum thickness) in the vertical direction (Z-direction), smaller than the thickness (e.g., maximum thickness) of the conductive pillar 50a in the vertical direction (Z-direction), and may have a length (e.g., maximum length) in the first horizontal direction (X-direction), greater than the thickness (e.g., maximum thickness) of the conductive pillar 50a in the vertical direction (Z-direction). In an example, each of the second grain 50a2 and the third grain 50a3 may extend from one of the lower surface and the upper surface of the conductive pillar 50a toward the other of the lower surface and the upper surface of the conductive pillar 50a. For example, the second grain 50a2 may extend from the lower surface of the conductive pillar 50a toward the upper surface of the conductive pillar 50a, and the third grain 50a3 may extend from the upper surface of the conductive pillar 50a toward the lower surface of the conductive pillar 50a.

In an example embodiment, referring to FIGS. 5A and 6B, one (e.g., a conductive pillar 50b) of the conductive pillars 50 may include a first grain 50b1, a second grain 50b2, and a third grain 50b3.

At least one of the first to third grains 50b1, 50b2 and 50b3 may have a length (e.g., maximum length) in the first horizontal direction (X-direction) which is at least twice as large as the thickness (e.g., maximum thickness) of the conductive pillar 50b in the vertical direction (Z-direction).

The first grain 50b1 may extend from a lower surface of the conductive pillar 50b to an upper surface of the conductive pillar 50b. For example, the first grain 50b1 may have a length (e.g., maximum length) in the first horizontal direction (X-direction) greater than the thickness (e.g., maximum thickness) of the conductive pillar 50b in the vertical direction (Z-direction). A maximum length of an upper region of the first grain 50b1 in of the first horizontal direction (X-direction) may be different from a maximum length of a lower region of the first grain 50b1 in the first horizontal direction (X-direction). For example, the maximum length of the upper region of the first grain 50b1 in the first horizontal direction (X-direction) may be greater than the maximum length of the lower region of the first grain 50b1 in the first horizontal direction (X-direction).

At least one of the second and third grains 50b2 and 50b3 may have a maximum thickness in the vertical direction (Z-direction), smaller than the maximum thickness of the conductive pillar 50b in the vertical direction (Z-direction), and may have a maximum length in the first horizontal direction (X-direction), greater than the maximum thickness of the conductive pillar 50b in the vertical direction (Z-direction). In an example, each of the second grain 50b2 and the third grain 50b3 may extend from one of the lower surface and the upper surface of the conductive pillar 50b toward the other of the lower surface and the upper surface of the conductive pillar 50b. For example, the second grain 50b2 may extend from the lower surface of the conductive pillar 50b toward the upper surface of the conductive pillar 50b, and the third grain 50b3 may extend from the upper surface of the conductive pillar 50b toward the lower surface of the conductive pillar 50b.

The second and third grains 50b2 and 50b3 may have different maximum lengths in the first horizontal direction (X-direction). For example, a maximum length of the second grain 50b2 in the first horizontal direction (X-direction) may be greater than a maximum length of the third grain 50b3 in the first horizontal direction (X-direction).

The maximum length of the second grain 50b2 in the first horizontal direction (X-direction) may be greater than three times the maximum thickness of the conductive pillar 50b in the vertical direction (Z-direction).

In the above-described example embodiment, since the transistors TR may be stacked in the vertical direction, the degree of integration of the semiconductor device 1 may be increased.

In the above-described embodiment, the conductive pillar 50 may have a convex side in the first horizontal direction (X-direction) (e.g., may have a side convex in the first horizontal direction (X direction)), and may be formed in a shape without a seam that may cause defects inside. Accordingly, the performance of the semiconductor device 1 including the conductive pillar 50 may be improved.

Next, various modified examples of the elements of the example embodiment described above will be described. The various modified examples of the elements of the example embodiment described above will be described with a focus on the modified or replaced elements. Here, the elements described above may be directly cited without a separate detailed description, or the description thereof may be omitted. For example, the "conductive pillars" described below that may replace the conductive pillars 50 described above may include grains 50a1, 50a2 and 50a3 as in FIG. 6A, or may include grains 50b1, 50b2 and 50b3 as in FIG. 6B. Additionally, the elements that may be modified or replaced as described below are described with reference to the drawings below, but the elements that may be modified or replaced may be combined with each other or with the elements described above to form a semiconductor device according to an example embodiment of the present disclosure.

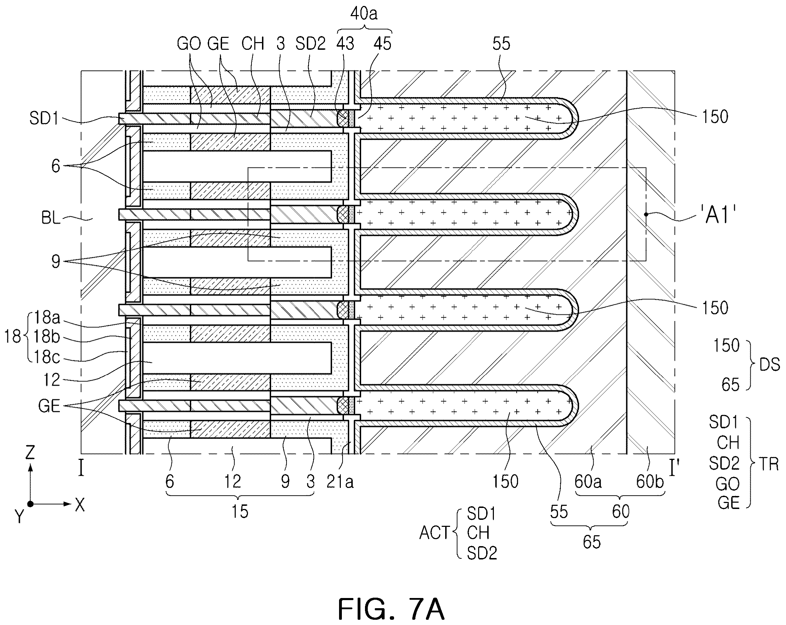

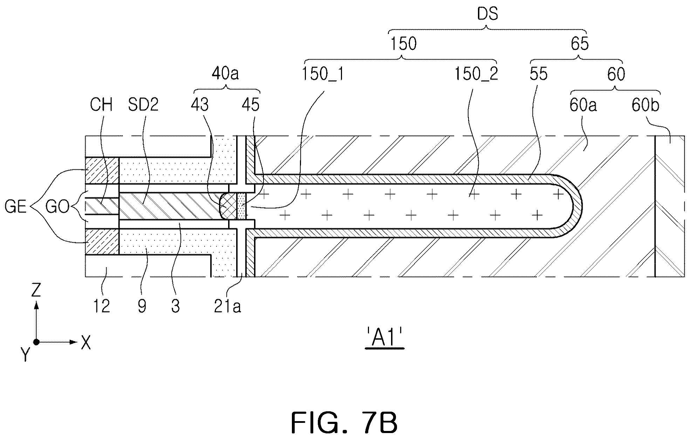

With reference to FIGS. 7A and 7B, an example of the semiconductor device 1 according to an example embodiment of the present disclosure will be described. FIG. 7A is a cross-sectional view illustrating a region taken along line I-I' of FIG. 4, and FIG. 7B is a partially enlarged view illustrating a region indicated by 'A1' of FIG. 7A.

In an example embodiment, with reference to FIGS. 7A and 7B, the conductive pillars 50 (see FIGS. 5A and 5B) described above may be replaced with conductive pillars 150 as in FIGS. 7A and 7B. Each of the conductive pillars 150 may include a first pillar region 150_1 in contact with a corresponding conductive pattern, among the conductive patterns 40a, and a second pillar region 150_2 extending from the first pillar region 150_1. The second pillar region 150_2 may have a thickness (e.g., maximum thickness) in the vertical direction (Z-direction), greater than a thickness (e.g., maximum thickness) of the first pillar region 150_1 in the vertical direction (Z-direction). The second pillar region 150_2 may have a length (e.g., maximum length) in the first horizontal direction (X-direction), greater than a length (e.g., maximum length) of the first pillar region 150_1 in the first horizontal direction (X-direction). For example, upper and lower surfaces of the first pillar region 150_1, when viewed along the second horizontal direction (Y-direction), may contact the buffer insulating layer 21a, while upper and lower surfaces of the second pillar region 150_2, when viewed along the second horizontal direction (Y-direction), may contact the dielectric layer 55. For example, the first pillar region 150_1 may be spaced apart from the dielectric layer 55. The first pillar region 150_1 may prevent the conductive pillar 150 from collapsing or deforming.

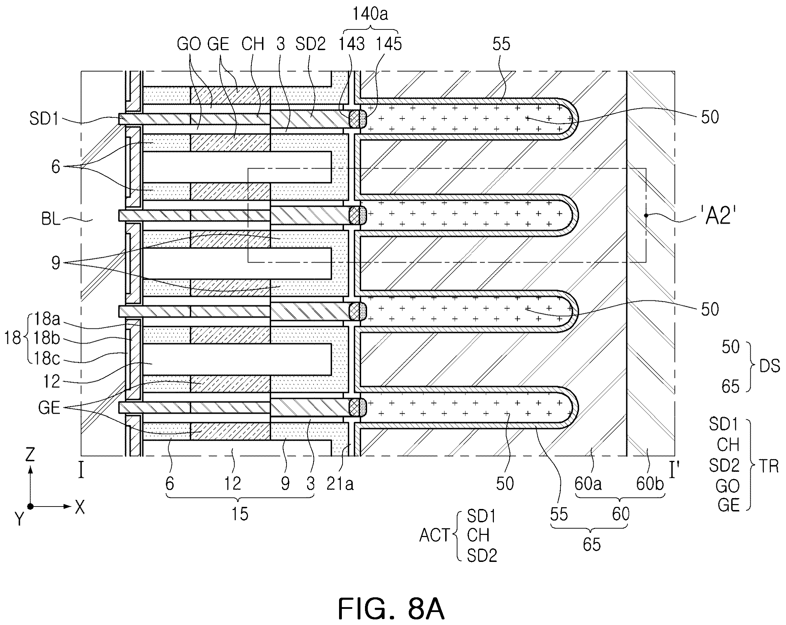

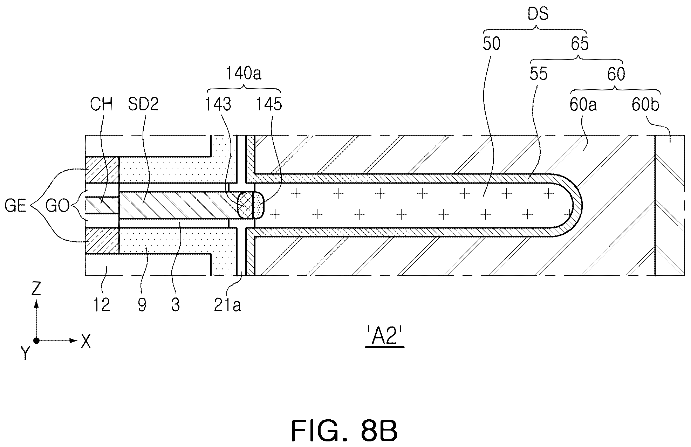

Referring to FIGS. 8A and 8B, an example of the semiconductor device 1 according to an example embodiment of the present disclosure will be described. FIG. 8A is a cross-sectional view illustrating a region taken along line I-I' of FIG. 4, and FIG. 8B is a partially enlarged view illustrating a region indicated by 'A2' of FIG. 8A.

In an example embodiment, referring to FIGS. 8A and 8B, the conductive patterns 40a (see FIGS. 5A and 5B) described above may be replaced with conductive patterns 140a as in FIGS. 8A and 8B. Each of the conductive patterns 140a may extend (e.g., protrude) into a corresponding conductive pillar, among the conductive pillars 50. For example, a first conductive pattern 140a, among the conductive patterns 140a, may extend into a corresponding first conductive pillar 50, among the conductive pillars 50. When viewed along the second horizontal direction (Y-direction), in the first conductive pattern 140a, a portion of the first conductive pattern 140a extending into the first conductive pillar 50 may have an upper surface, a lower surface, and a side surface that are in contact with the first conductive pillar 50. In an example embodiment, each of the conductive patterns 140a may include a metal-semiconductor compound region 143 and a nitrided conductive region 145. For example, the nitrided conductive region 145 of the first conductive pattern 140a among the conductive patterns 140a may extend into the corresponding first conductive pillar 50 among the conductive pillars 50. When viewed along the second horizontal direction (Y-direction), in the first conductive pattern 140a, the nitrided conductive region 145 may have an upper surface, a lower surface, and a side surface that are in contact with the first conductive pillar 50, and/or the metal-semiconductor compound region 143 may be spaced apart from the first conductive pillar 50. The conductive patterns 140a may extend into the corresponding conductive pillars 50, among the conductive pillars 50, thereby preventing defects such as deformation of the conductive pillars 50.

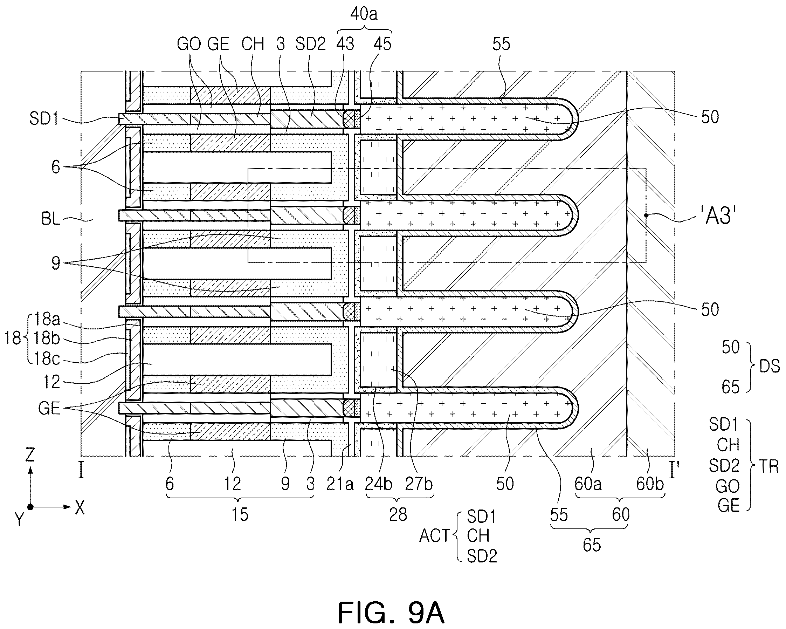

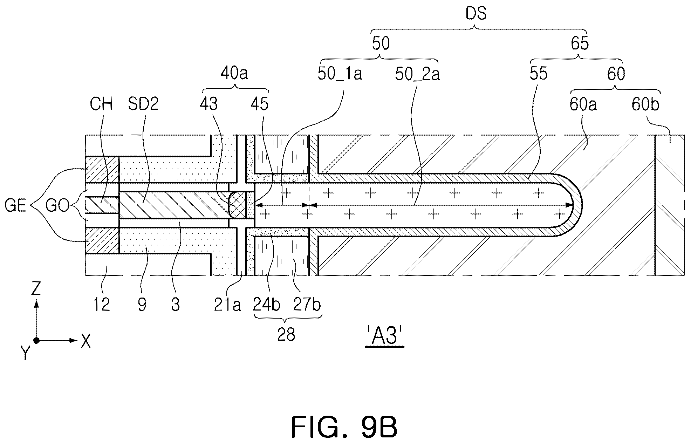

With reference to FIGS. 9A and 9B, an example of the semiconductor device 1 according to an example embodiment of the present disclosure will be described. FIG. 9A is a cross-sectional view illustrating a region taken along line I-I' of FIG. 4, and FIG. 9B is a partially enlarged view illustrating a region indicated by 'A3' of FIG. 9A.

In an example embodiment, referring to FIGS. 9A and 9B, the semiconductor device 1 (see FIG. 1) may further include an insulating support pattern 28 capable of preventing the conductive pillars 50 (see FIGS. 5A and 5B) from collapsing or deforming. The insulating support pattern 28 may be disposed between the pattern structure 65 and the buffer insulating layer 21a in the first horizontal direction (X-direction). The insulating support pattern 28 may include an insulating liner 24b and an insulating pattern 27b. The insulating liner 24b may be disposed between the insulating pattern 27b and the buffer insulating layer 21a in the first horizontal direction (X-direction) and may cover a lower surface and an upper surface of the insulating pattern 27b when viewed along the second horizontal direction (Y-direction). The insulating liner 24b may include nitride, and the insulating pattern 27b may include oxide. For example, the insulating liner 24b may include silicon nitride, and the insulating pattern 27b may include silicon oxide. Each of the conductive pillars 50 may include a first region 50_1a (e.g., a first horizontal region) in contact with the insulating support pattern 28 and a second region 50_2a (e.g., a second horizontal region) extending from the first region 50_1a in the first horizontal direction (X-direction) and covered with the pattern structure 65 including the dielectric layer 55 and the electrode pattern 60. For example, in the first region 50_1a, upper and lower surfaces of the conductive pillar 50 may be in contact with the insulating support pattern 28. For example, in the second region 50_2a, upper and lower surfaces of the conductive pillar 50 may be covered with the dielectric layer 55 and the electrode pattern 60. In each of the conductive pillars 50, a length of the second region 50_2a in the first horizontal direction (X-direction) may be greater than a length of the first region 50_1a in the first horizontal direction (X-direction).

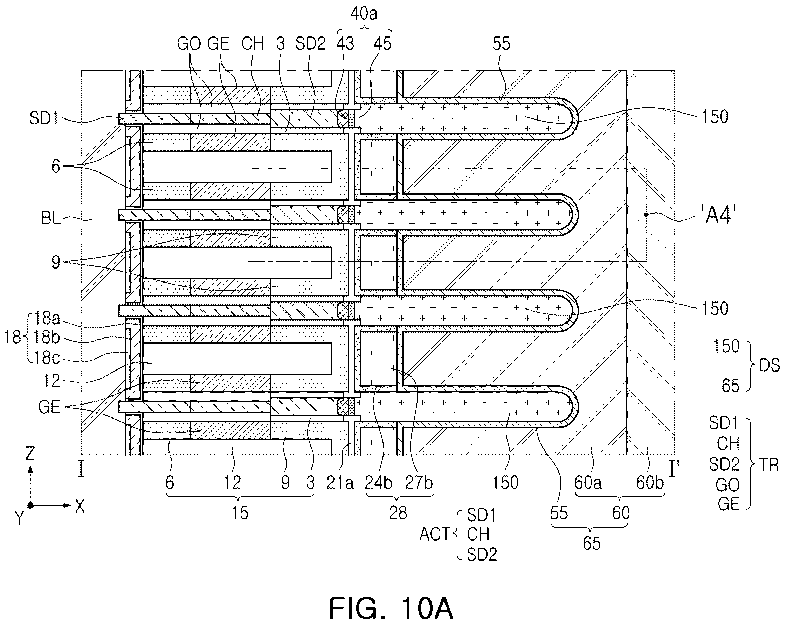

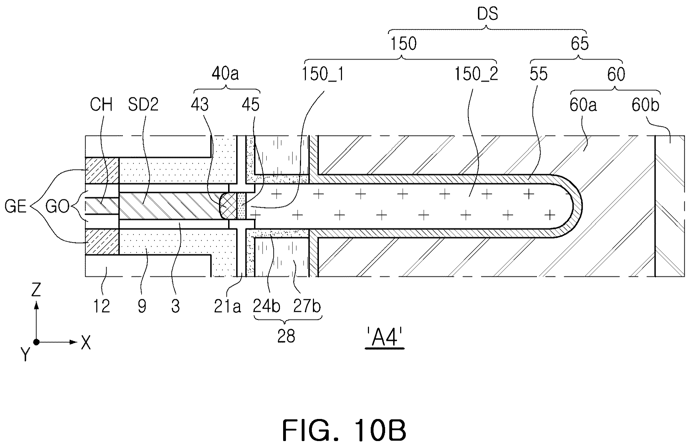

Referring to FIGS. 10A and 10B, an example of the semiconductor device 1 according to an example embodiment of the present disclosure will be described. FIG. 10A is a cross-sectional view illustrating a region taken along line I-I' of FIG. 4, and FIG. 10B is a partially enlarged view illustrating a region indicated by 'A4' of FIG. 10A.

In an example embodiment, referring to FIGS. 10A and 10B, the semiconductor device 1 (see FIG. 1) may further include an insulating support pattern 28 capable of preventing the conductive pillars 150 (see FIGS. 7A and 7B) described in FIGS. 7A and 7B from collapsing or deforming. The insulating support pattern 28 may be disposed between the pattern structure 65 and the buffer insulating layer 21a in the first horizontal direction (X-direction), as described in FIGS. 9A and 9B, and may include the insulating liner 24b and the insulating pattern 27b. Similar to an embodiment of FIGS. 9A and 9B, each of the conductive pillars 150 may include a first region in contact with the insulating support pattern 28 and a second region extending from the first region in the first horizontal direction (X-direction) and covered with the pattern structure 65. For example, as illustrated in FIGS. 10A and 10B, each of the conductive pillars 150 may include a first pillar region 150_1 in contact with a corresponding conductive pattern among the conductive patterns 40a, and a second pillar region 150_2 extending from the first pillar region 150_1, and the second pillar region 150_2 of each of the conductive pillars 150 may include a first region in contact with the insulating support pattern 28 and a second region extending from the first region in the first horizontal direction (X-direction) and covered with the pattern structure 65.

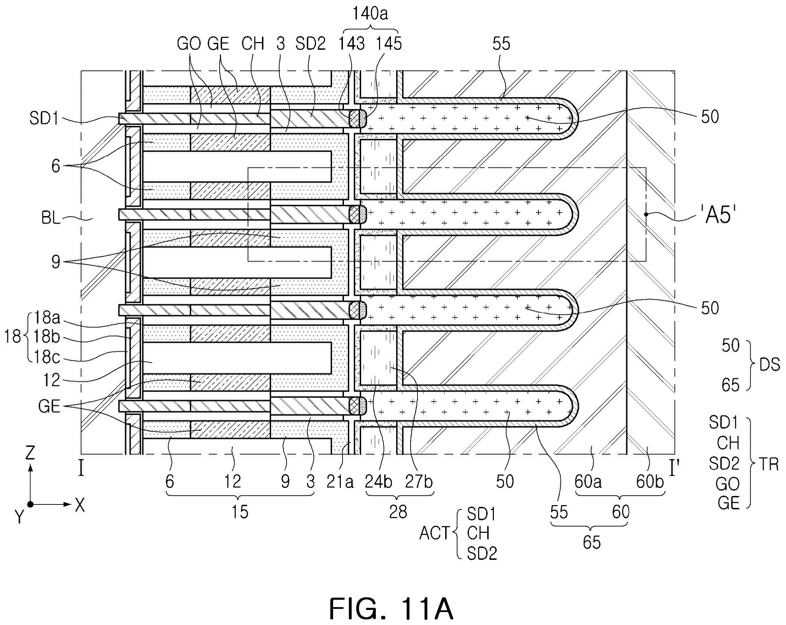

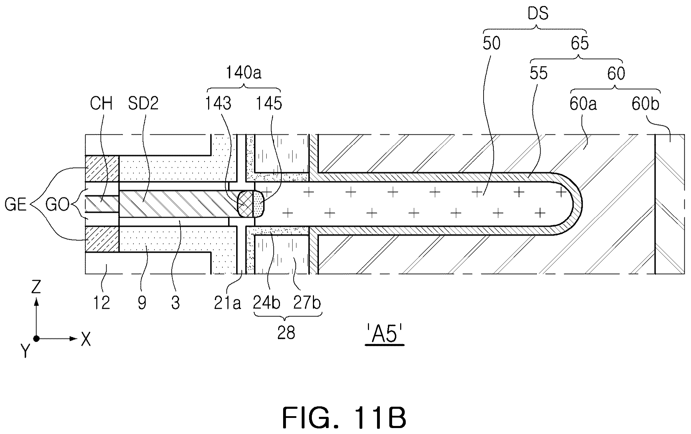

With reference to FIGS. 11A and 11B, an example of the semiconductor device 1 according to an example embodiment of the present disclosure will be described. FIG. 11A is a cross-sectional view illustrating a region taken along line I-I' of FIG. 4, and FIG. 11B is a partially enlarged view illustrating a region indicated by 'A5' of FIG. 11A.

In an example embodiment, referring to FIGS. 11A and 11B, the semiconductor device 1 (see FIG. 1) may further include an insulating support pattern 28 capable of preventing the conductive pillars 50 (see FIGS. 8A and 8B) connected to the conductive patterns 140a (see FIGS. 8A and 8B) described in FIGS. 8A and 8B from collapsing or deforming. The insulating support pattern 28 may be disposed between the pattern structure 65 and the buffer insulating layer 21a in the first horizontal direction (X-direction), as described in FIGS. 9A and 9B, and may include the insulating liner 24b and the insulating pattern 27b. Similar to an embodiment of FIGS. 9A and 9B, each of the conductive pillars 50 may include a first region in contact with the insulating support pattern 28 and a second region extending from the first region in the first horizontal direction (X-direction) and covered with the pattern structure 65.

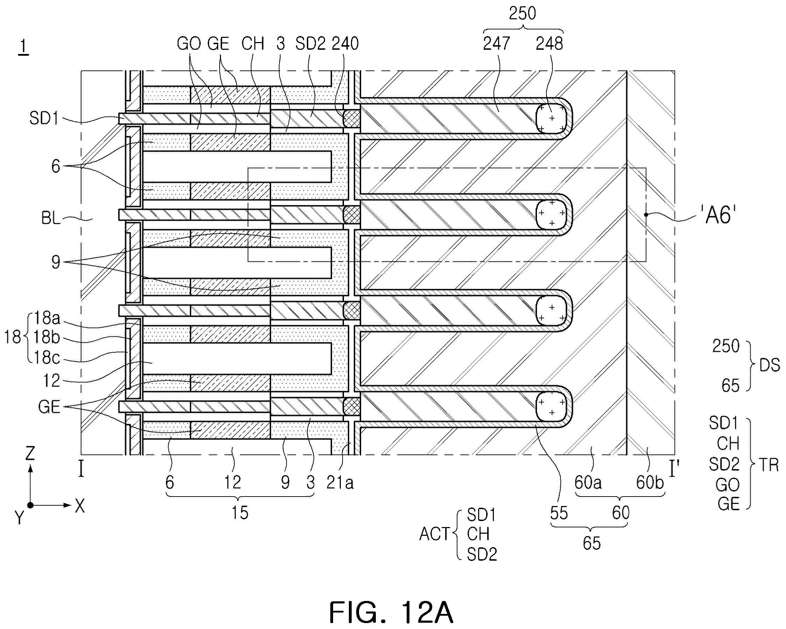

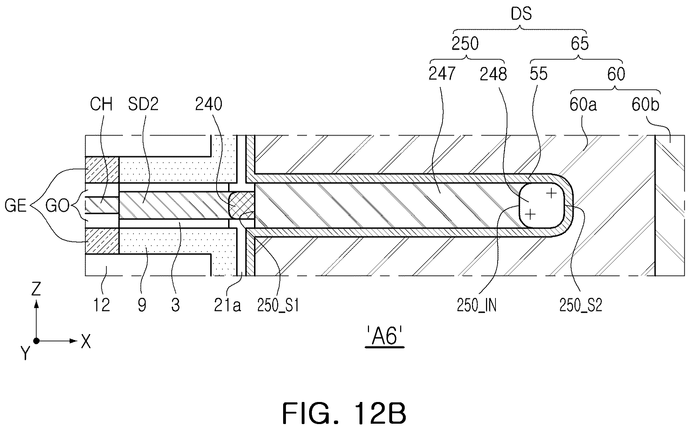

Referring to FIGS. 12A and 12B, an example of the semiconductor device 1 according to an example embodiment of the present disclosure will be described. FIG. 12A is a cross-sectional view illustrating a region taken along line I-I' of FIG. 4, and FIG. 12B is a partially enlarged view illustrating a region indicated by 'A6' of FIG. 12A.

In an example embodiment, referring to FIGS. 12A and 12B, the conductive patterns 40a (see FIGS. 5A and 5B) described above may be replaced with conductive patterns 240 as in FIGS. 12A and 12B. The conductive patterns 240 may be formed of a metal-semiconductor compound.

The conductive pillars 50 (see FIGS. 5A and 5B) described above may be replaced with conductive pillars 250 as in in FIGS. 12A and 12B. Each of the conductive pillars 250 may include a pillar pattern 247 and a capping pattern 248 sequentially arranged in the first horizontal direction (X-direction). The pillar patterns 247 of the conductive pillars 250 may be connected to the conductive patterns 240. For example, the pillar pattern 247 of each of the conductive pillars 250 may be in contact with a corresponding conductive pattern 240 of the conductive patterns 240.

Each of the conductive pillars 250 may have a first side surface 250_S1 adjacent to (e.g., facing) a corresponding transistor among the transistors TR, and a second side surface 250_S2 opposite to the first side surface 250_S1. In each of the conductive pillars 250, a side surface of the pillar pattern 247 may be the first side surface 250_S1, a side surface of the capping pattern 248 may be the second side surface 250_S2, and the pillar pattern 247 may have a third side surface 250_IN in contact with the capping pattern 248. The third side surface 250_IN of the pillar pattern 247 may be an interface between the pillar pattern 247 and the capping pattern 248. The third side surface 250_IN of the pillar pattern 247 may be concave in a direction oriented toward the second source/drain region SD2 of the transistor TR. The second side surface 250_S2 of the capping pattern 248 may be convex in a direction away from the second source/drain region SD2 of the transistor TR. For example, when viewed along the second horizontal direction (Y-direction) the third side surface 250_IN may have a curved shape such that a middle portion of the third side surface 250_IN is closer to the transistor TR than upper and lower portions of the third side surface 250_IN. For example, a direction of curvature of the third side surface 250_IN may be opposite to a direction of curvature of the second side surface 250_S2.

The third side surface 250_IN of the pillar pattern 247 may be covered with the capping pattern 248 and may be protected by the capping pattern 248. The capping pattern 248 may play a capping role to prevent defects from occurring due to the pillar pattern 247. For example, when the capping pattern 248 is in contact with the third side surface 250_IN of the pillar pattern 247, the capping pattern 248 may prevent a seam inside the pillar pattern 247 from being in contact with the dielectric layer 55 of the data storage structure DS.

The pillar pattern 247 may be referred to as a first pillar pattern, and the capping pattern 248 may be referred to as a second pillar pattern.

A maximum length of the pillar pattern 247 in the first horizontal direction (X-direction) may be greater than a maximum length of the capping pattern 248 in the first horizontal direction (X-direction).

A maximum length of the pillar pattern 247 in the first horizontal direction (X-direction) may be greater than a width (e.g., maximum width) or thickness (e.g., maximum thickness) of the pillar pattern 247 in the vertical direction (Z-direction).

Among the pillar patterns 247 and the capping patterns 248 sequentially arranged in the first horizontal direction (X-direction), a portion of the pillar pattern 247 and a portion of the capping pattern 248 adjacent to each other may have substantially the same thickness in the vertical direction (Z-direction).

In an example, the pillar pattern 247 may include a first conductive material, and the capping pattern 248 may include a second conductive material different from the first conductive material. The pillar pattern 247 may be formed of Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or combinations thereof. The capping pattern 248 may be formed of Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, or combinations thereof. For example, the pillar pattern 247 may be formed of TiN or WN, and the capping pattern 248 may be formed of Mo or W.

In an example, the pillar pattern 247 may include a conductive material formed by a first semiconductor process, and the capping pattern 248 may include a conductive material formed by a second semiconductor process. For example, the pillar pattern 247 may be formed by performing a deposition process to form a material layer and partially etching the material layer. The capping pattern 248 may be formed of a material grown from the pillar pattern 247.

In an example, the capping pattern 248 may be formed of a single grain. For example, the capping pattern 248 may be formed of a single crystal conductive material.

In another example, the capping pattern 248 may include a plurality of grains.

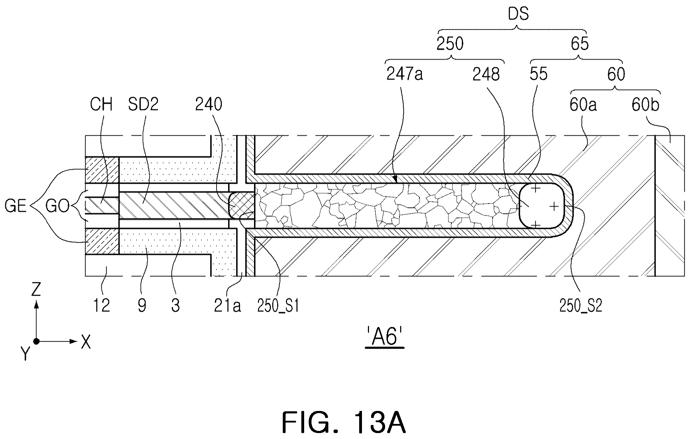

Next, an example of the above-described pillar pattern 247 (see FIG. 12B) will be described with reference to FIG. 13A. FIG. 13A is a partially enlarged view illustrating a region indicated by 'A6' of FIG. 12A.

In an example embodiment, referring to FIG. 13A, the capping pattern 248 may be formed of a single crystal, and the above-described pillar pattern 247 (see FIG. 12B) may be replaced with a pillar pattern 247a having a plurality of grains. One of the plurality of grains of the pillar pattern 247a may have a size smaller than that of the single crystal of the capping pattern 248. For example, in the first horizontal direction (X-direction), a maximum width of one of the grains of the pillar pattern 247a may be smaller than a maximum width of the capping pattern 248. In the first horizontal direction (X-direction), each of the grains of the pillar pattern 247a may be smaller than the maximum width of the capping pattern 248. For example, in the first horizontal direction (X-direction), the maximum width of each of the grains of the pillar pattern 247a may be smaller than the maximum width of the capping pattern 248.

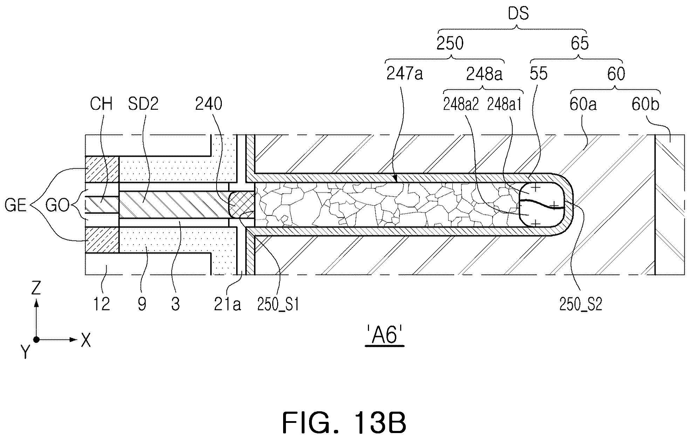

Next, an example of the capping pattern 248 (see FIG. 13A) described in FIG. 13A will be described with reference to FIG. 13B. FIG. 13B is a partially enlarged view illustrating a region indicated by 'A6' of FIG. 12A.

In an example embodiment, referring to FIG. 13B, the capping pattern 248 (see FIG. 13A) described in FIG. 13A may be replaced with a capping pattern 248a including a plurality of grains 248a1 and 248a2.

The plurality of grains 248a1 and 248a2 of the capping pattern 248a may include a first grain 248a1 and a second grain 248a2. At least one of the plurality of grains 248a1 and 248a2 may extend from a portion in contact with the pillar pattern 247a to the second side surface 250_S2. For example, the first grain 248a1 and the second grain 248a2 may both extend from a portion in contact with the pillar pattern 247a to the second side surface 250_S2. In the first horizontal direction (X-direction), a maximum width of at least one of the plurality of grains 248a1 and 248a2 may be greater than a maximum width of each of the grains of the pillar pattern 247a.

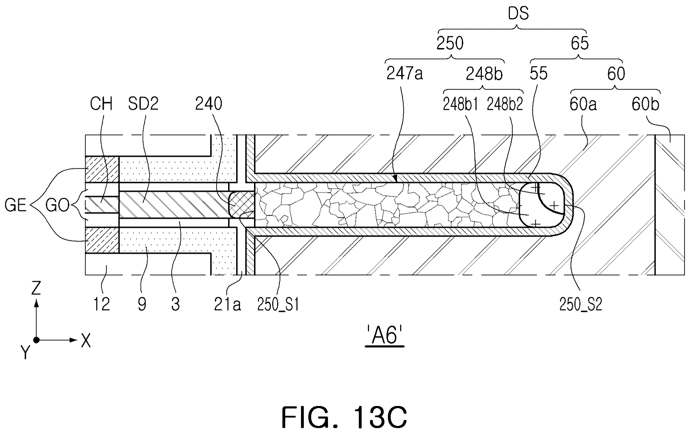

Next, an example of the capping pattern 248 will be described with reference to FIG. 13C. FIG. 13C is a partially enlarged view illustrating a region indicated by 'A6' of FIG. 12A.

In an example embodiment, referring to FIG. 13C, the capping pattern 248 (see FIG. 13A) described in FIG. 13A may be replaced with a capping pattern 248b including a plurality of grains 248b1 and 248b2 as in FIG. 13C.

The plurality of grains 248b1 and 248b2 of the capping pattern 248b may include a first grain 248b1 and a second grain 248b2. The first grain 248b1 may horizontally extend from a portion in contact with the pillar pattern 247a to the second side surface 250_S2, and may vertically extend from an upper surface (e.g., an uppermost surface) of the capping pattern 248b to a lower surface (e.g., a lowermost surface) of the capping pattern 248b. The second grain 248b2 may be spaced apart from the pillar pattern 247a by the first grain 248b1. In the first horizontal direction (X-direction), a maximum width of the first grain 248b1 may be greater than a maximum width of each of the grains of the pillar pattern 247a.

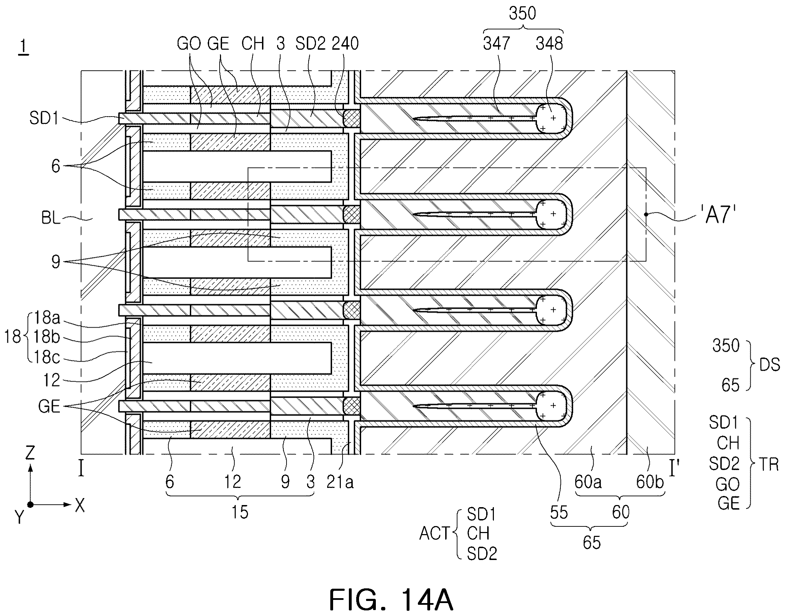

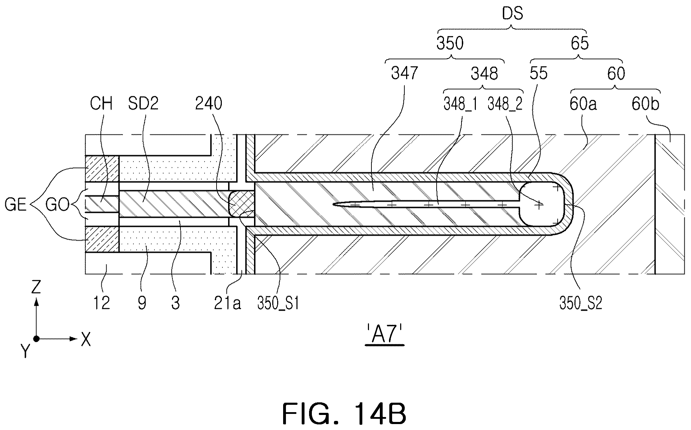

With reference to FIGS. 14A and 14B, an example of the conductive pillar 250 (see FIGS. 12A and 12B) described in FIGS. 12A and 12B will be described. FIG. 14A is a cross-sectional view illustrating a region taken along line I-I' of FIG. 4, and FIG. 14B is a partially enlarged view illustrating a region indicated by 'A7' of FIG. 14A.

In an example embodiment, referring to FIGS. 14A and 14B, the conductive pillar 250 (see FIGS. 12A and 12B) described in FIGS. 12A and 12B may be replaced with a conductive pillar 350 as in FIGS. 14A and 14B. The pillar pattern 247 (see FIGS. 12A and 12B) described in FIGS. 12A and 12B may be replaced with a pillar pattern 347 as in FIGS. 14A and 14B, and the capping pattern 248 (see FIGS. 12A and 12B) described in FIGS. 12A and 12B may be replaced with a capping pattern 348 as in FIGS. 14A and 14B.

The conductive pillar 350 may have a first side surface 350_S1 connected to the conductive pattern 240 and a second side surface 350_S2 opposite to the first side surface 350_S1 in the first horizontal direction (X-direction). The conductive pillar 350 may include the pillar pattern 347 and the capping pattern 348 sequentially arranged in the first horizontal direction (X-direction).

The capping pattern 348 may include a first portion 348_2 and a second portion 348_1 extending from the first portion 348_2 into the pillar pattern 347 and surrounded by the pillar pattern 347. At least a portion of the first portion 348_2 of the capping pattern 348 may not vertically overlap the pillar pattern 347. For example, the second portion 348_1 of the capping pattern 348 may extend or protrude away from the first portion 348_2 into the pillar pattern 347 in the first horizontal direction (X-direction) such that the pillar pattern 347 is between the second portion 348_1 and the upper surface of the conductive pillar 350, between the second portion 348_1 and the lower surface of the conductive pillar 350, and between the second portion 348_1 and the conductive pattern 240.

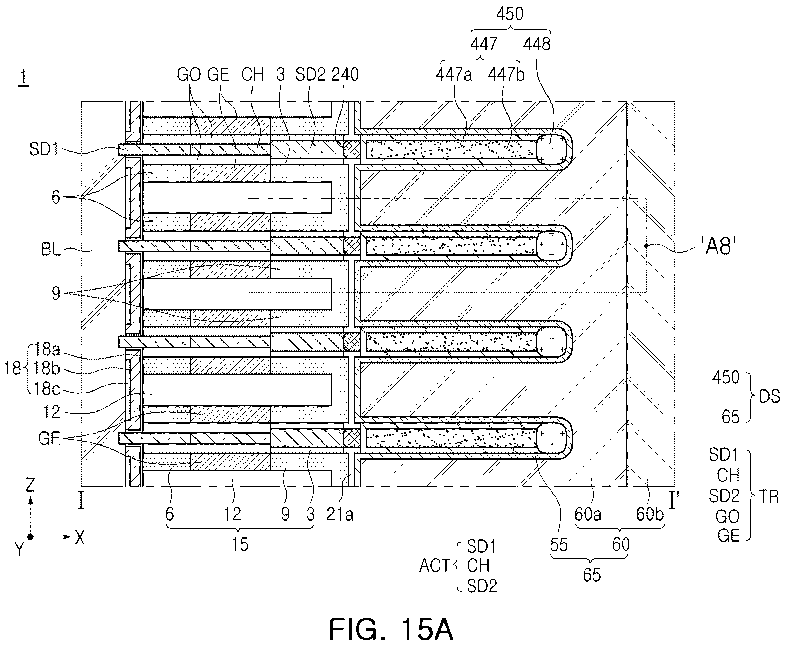

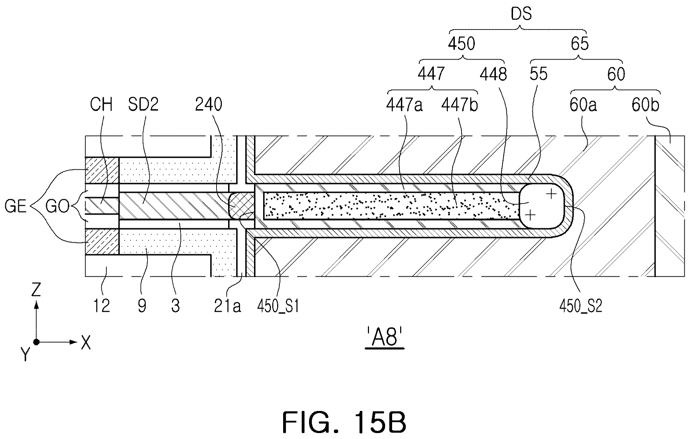

With reference to FIGS. 15A and 15B, an example of the conductive pillar 250 (see FIGS. 12A and 12B) described in FIGS. 12A and 12B will be described. FIG. 15A is a cross-sectional view illustrating a region taken along line I-I' of FIG. 4, and FIG. 15B is a partially enlarged view illustrating a region indicated by 'A8' of FIG. 15A.

The conductive pillar 250 (see FIGS. 12A and 12B) described in FIGS. 12A and 12B may be replaced with a conductive pillar 450 as in FIGS. 15A and 15B. The pillar pattern 247 (see FIGS. 12A and 12B) described in FIGS. 12A and 12B may be replaced with a pillar pattern 447 as in FIGS. 15A and 15B, and the capping pattern 248 (see FIGS. 12A and 12B) described in FIGS. 12A and 12B may be replaced with a capping pattern 448 as in FIGS. 15A and 15B.

The conductive pillar 450 may have a first side surface 450_S1 connected to (e.g., in contact with) the conductive pattern 240 and a second side surface 450_S2 opposite to the first side surface 450_S1 in the first horizontal direction (X-direction). The conductive pillar 450 may include the pillar pattern 447 and the capping pattern 448 sequentially arranged in the first horizontal direction (X-direction).

The pillar pattern 447 may include a first material layer 447a and a second material layer 447b. The first material layer 447a may cover a lower surface and an upper surface of the second material layer 447b, and may extend between an adjacent transistor among the transistors TR and the second material layer 447b. The first material layer 447a may be disposed between the second material layer 447b and the conductive pattern 240. The capping pattern 448 may be in contact with the first material layer 447a and the second material layer 447b.

In an example, the first material layer 447a may include at least one of TiN, TaN, WN, NbN, TiAlN, TiSiN, TaSiN, and RuTiN, and the second material layer 447b may include at least one of Ti, Ta, Ru, W, Mo, Pt, Ni, and Co.

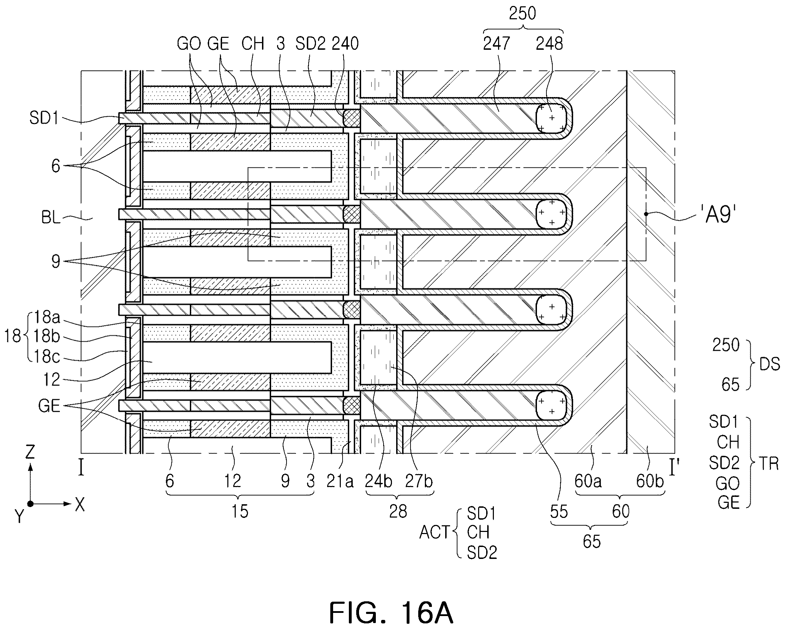

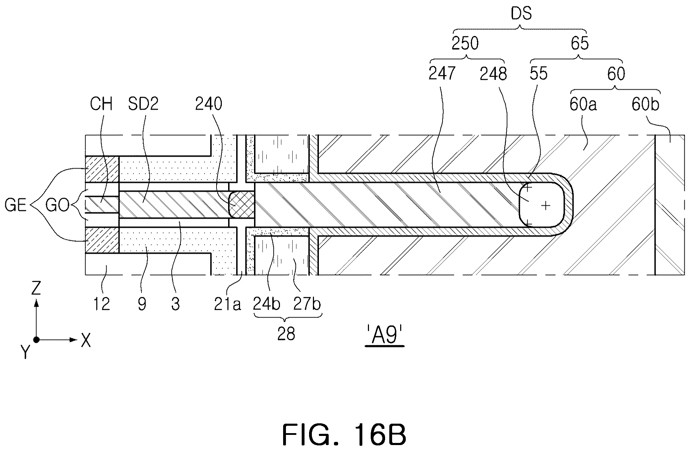

Referring to FIGS. 16A and 16B, an example of the semiconductor device 1 including both the conductive pillars 250 (see FIGS. 12A and 12B) and the insulating support pattern 28 (see FIGS. 9A and 9B) described above will be described. FIG. 16A is a cross-sectional view illustrating a region taken along line I-I' of FIG. 4, and FIG. 16B is a partially enlarged view illustrating a region indicated by 'A9' of FIG. 16A.

Referring to FIGS. 16A and 16B, the semiconductor device 1 (see FIG. 1) may include the conductive pillars 250 (see FIGS. 12A and 12B) and the insulating support pattern 28 (see FIGS. 9A and 9B) described above. As described in FIGS. 9A and 9B above, the insulating support pattern 28 may prevent the conductive pillars 250 from collapsing or deforming. As described in FIGS. 9A and 9B above, the insulating support pattern 28 may be disposed between the pattern structure 65 and the buffer insulating layer 21a.

The above-described pillar pattern 247 may include a first region vertically overlapping the insulating support pattern 28 and a second region extending from the first region in the first horizontal direction (X-direction) and not vertically overlapping the insulating support pattern 28 and contacting the capping pattern 248. An upper surface and a lower surface of the first region of the pillar pattern 247 may be in contact with the insulating support pattern 28, and an upper surface and a lower surface of the second region of the pillar pattern 247 may be in contact with the dielectric layer 55. The capping pattern 248 may be spaced apart from the insulating support pattern 28 in the first horizontal direction (X-direction).

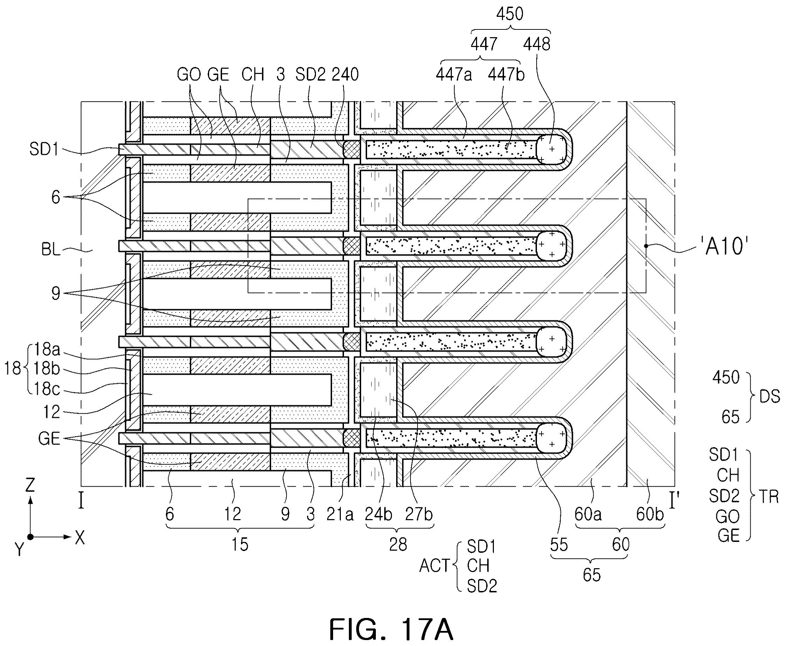

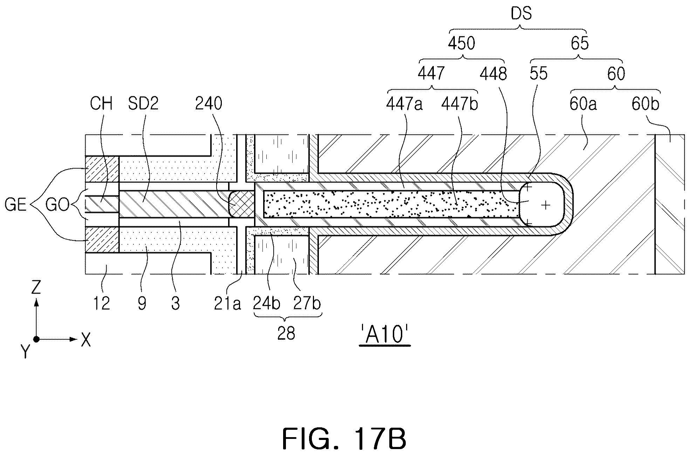

Referring to FIGS. 17A and 17B, an example of the semiconductor device 1 in which the conductive pillar 250 described in FIGS. 16A and 16B above may be replaced with the conductive pillar 450 (see FIGS. 15A and 15B) described in FIGS. 15A and 15B above will be described. FIG. 17A is a cross-sectional view illustrating a region taken along line I-I' of FIG. 4, and FIG. 17B is a partially enlarged view illustrating a region indicated by 'A10' of FIG. 17A.

Referring to FIGS. 17A and 17B, the conductive pillar 250 described in FIGS. 16A and 16B above may be replaced with the conductive pillar 450 (see FIGS. 15A and 15B) described in FIGS. 15A and 15B above. Accordingly, the semiconductor device 1 (see FIG. 1) may include the conductive pillar 450 (see FIG. 15A and FIG. 15B) described in FIG. 15A and FIG. 15B above and the insulating support pattern 28 (see FIG. 16A and FIG. 16B) described in FIG. 16A and FIG. 16B above.

The first material layer 447a of the pillar pattern 447 described above may be in contact with the insulating support pattern 28 and the dielectric layer 55, and the second material layer 447b of the pillar pattern 447 described above may be separated from the insulating support pattern 28 and the dielectric layer 55 by the first material layer 447a. The capping pattern 448 may be separated from the insulating support pattern 28 in the first horizontal direction (X-direction).

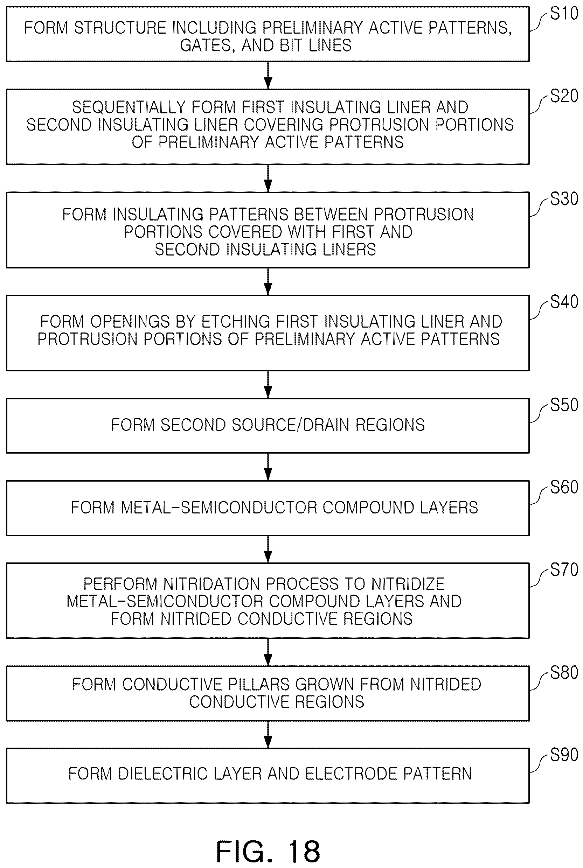

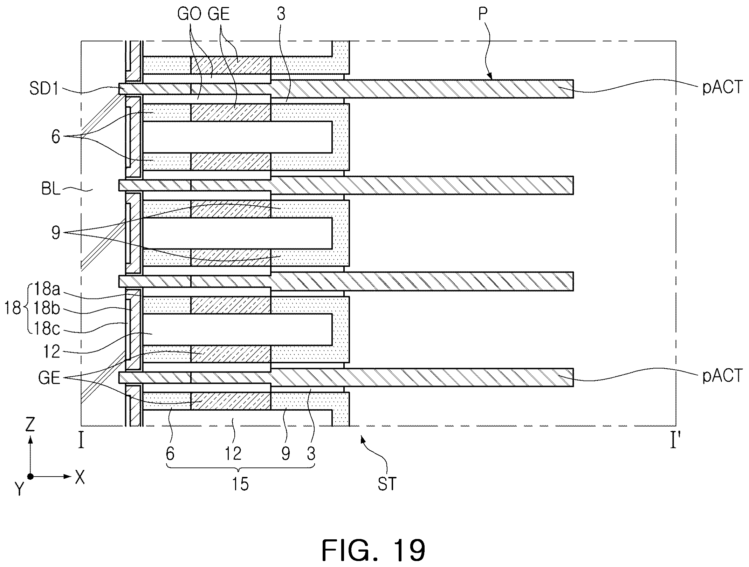

Next, with reference to FIGS. 18 to 28, an example of a method of forming a semiconductor device according to an example embodiment of the present disclosure will be described. In FIGS. 18 to 28, FIG. 18 is a process flow diagram illustrating an example of a method of forming a semiconductor device according to an example embodiment of the present disclosure, and FIGS. 19 to 28 are cross-sectional views illustrating a region corresponding to a region taken along line I-I' of FIG. 4, so as to explain an example of a method of forming a semiconductor device according to an example embodiment of the present disclosure.

Referring to FIGS. 18 and 19, a structure ST including preliminary active patterns pACT, gates GO and GE, and bit lines BL may be formed (S10).

Each of the preliminary active patterns pACT may have a bar shape extending in the first horizontal direction (X-direction). The preliminary active patterns pACT may be arranged three-dimensionally. For example, the above-described preliminary active patterns pACT may be stacked to be spaced apart from each other in the vertical direction (Z-direction), and may be arranged while being spaced apart from each other in a second horizontal direction (Y-direction), perpendicular to the first horizontal direction (X-direction). Each of the bit lines BL may extend in the vertical direction (Z-direction). The bit lines BL may be arranged while being spaced apart from each other in the second horizontal direction (Y-direction). Each of the bit lines BL may be connected to a corresponding group of the preliminary active patterns pACT stacked to be spaced apart from each other in the vertical direction (Z-direction).

Hereinafter, one bit line BL, among the bit lines BL, will be described.

Each of the preliminary active patterns pACT may include a first source/drain region SD1 formed in a region adjacent to the bit line BL. The gates GO and GE may include gate electrodes GE respectively surrounding the preliminary active patterns pACT and extending in the second horizontal direction (Y-direction), and gate dielectric layers GO between the gate electrodes GE and the preliminary active patterns pACT.

The structure ST may further include a first insulating structure 15 including a plurality of insulating layers 3, 6, 9 and 12 and a second insulating structure 18 including a plurality of insulating layers 18a, 18b and 18c. The first insulating structure 15 and the second insulating structure 18 may be formed between adjacent preliminary active patterns pACT, and the second insulating structure 18 may be formed between the bit line BL and the first insulating structure 15.

Each of the preliminary active patterns pACT may include a protrusion portion P extending in the first horizontal direction (X-direction) further than (e.g., beyond) an end of the first insulating structure 15.

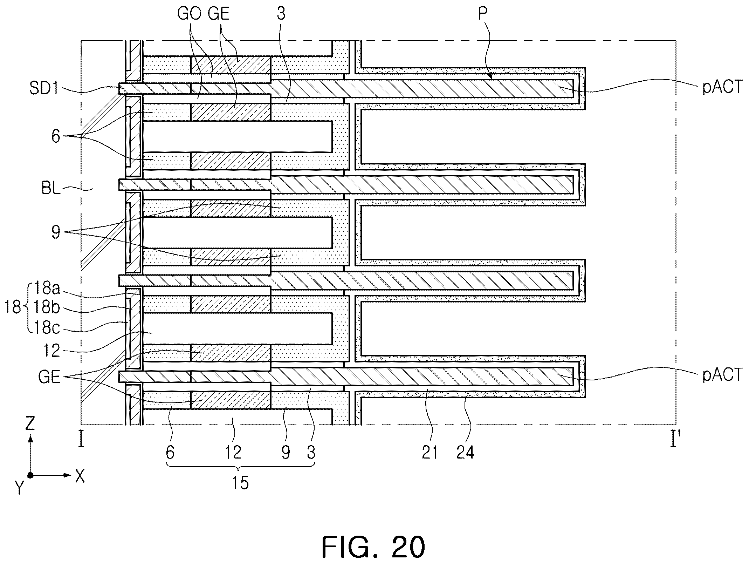

Referring to FIGS. 18 and 20, a first insulating liner 21 and a second insulating liner 24 covering the protrusion portions P of the preliminary active patterns pACT may be sequentially formed (S20). The first insulating liner 21 may be formed of an oxide, and the second insulating liner 24 may be formed of a nitride. For example, the first insulating liner 21 may be formed of silicon oxide, and the second insulating liner 24 may be formed of silicon nitride.

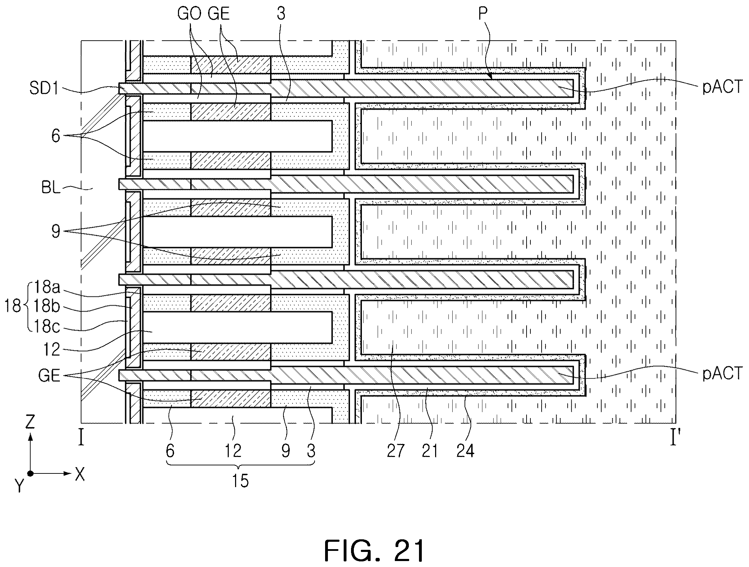

Referring to FIGS. 18 and 21, an insulating layer 27 filling the space between the protrusion portions P of the preliminary active patterns pACT covered with the first and second insulating liners 21 and 24 and covering the second insulating liner 24 may be formed. The insulating layer 27 may be formed of oxide. For example, the insulating layer 27 may be formed of silicon oxide.

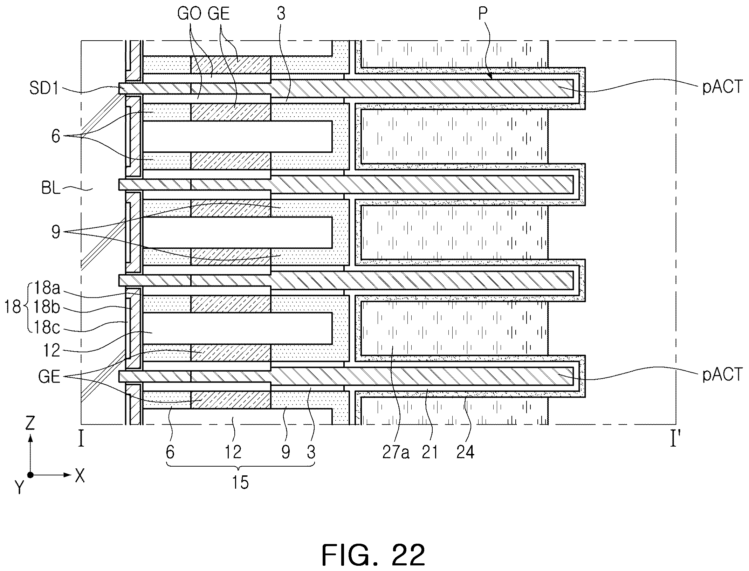

Referring to FIGS. 18 and 22, the insulating layer 27 may be partially etched to form a partially etched insulating layer 27a. The protrusion portions P of the preliminary active patterns pACT covered with the first and second insulating liners 21 and 24 may have a shape further protruding in the first horizontal direction (X-direction) than an end surface of the partially etched insulating layer 27a.

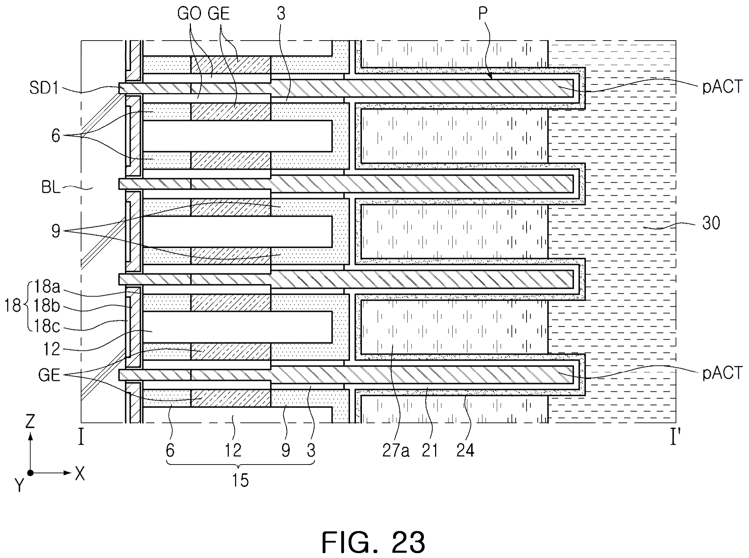

Referring to FIG. 18 and FIG. 23, a mask layer 30 covering the partially etched insulating layer 27a and the protrusion portions P of the preliminary active patterns pACT covered with the first and second insulating liners 21 and 24 further protruding in the first horizontal direction (X-direction) than the partially etched insulating layer 27a may be formed. The mask layer 30 may be formed of a nitride. For example, the mask layer 30 may be formed of a silicon nitride.

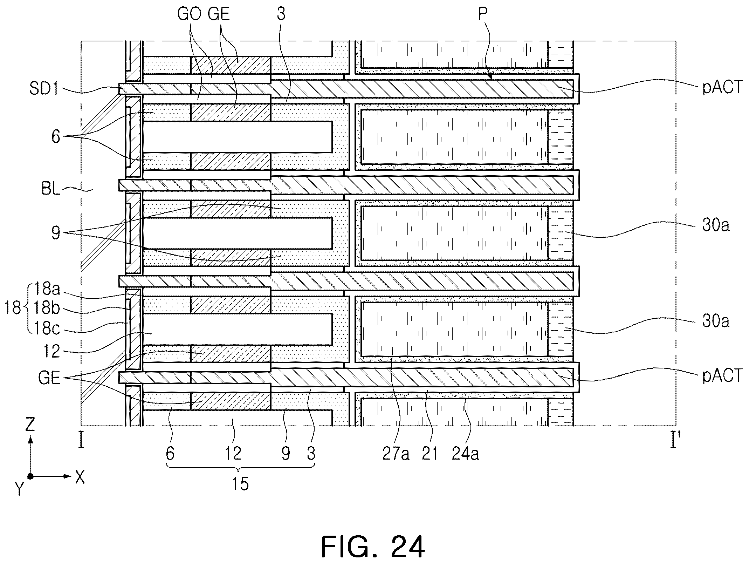

Referring to FIGS. 18 and 24, insulating patterns 24a, 27a and 30a may be formed between the protrusion portions P of the preliminary active patterns pACT covered with the first and second insulating liners 21 and 24 (S30). Forming the insulating patterns 24a, 27a and 30a may include forming a mask pattern 30a exposing the second insulating liner 24 (see FIG. 23) by etching the mask layer 30, and forming the remaining insulating liner 24a by etching the exposed portion of the second insulating liner 24 (see FIG. 23). The insulating patterns 24a, 27a and 30a may include the remaining insulating liner 24a, the mask pattern 30a, and the partially etched insulating layer 27a.

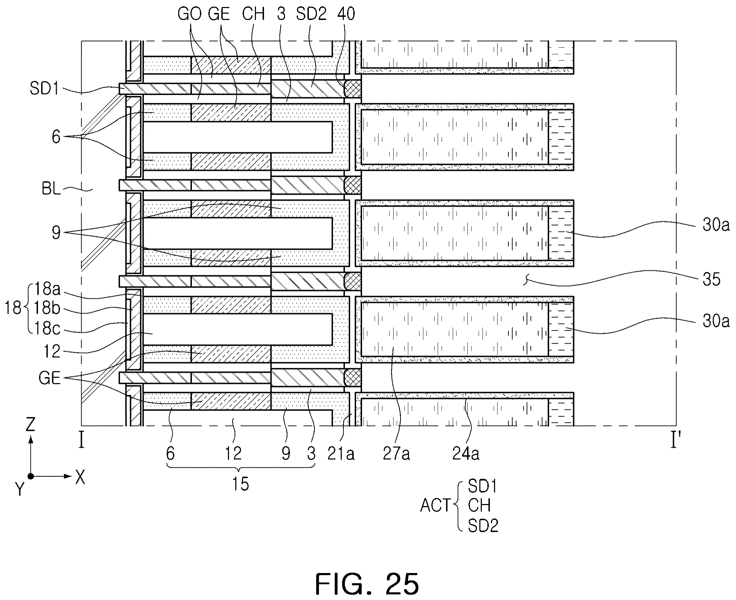

Referring to FIG. 18 and FIG. 25, the first insulating liner 21 (see FIG. 24) and the protrusion portions P (see FIG. 24) of the preliminary active patterns pACT may be etched to form openings 35 (S40). Forming the openings 35 may include etching the first insulating liner 21 (see FIG. 24) using the insulating patterns 24a, 27a and 30a as an etching mask to expose the protrusion portions P (see FIG. 24) of the preliminary active patterns pACT, and etching the exposed protrusion portions P (see FIG. 24) of the preliminary active patterns pACT. The first insulating liner 21 (see FIG. 24) may be etched and the remaining portion thereof may be formed as a buffer insulating layer 21a, and the preliminary active patterns pACT may be etched and the remaining portion thereof may be formed as the active patterns ACT.

Second source/drain regions SD2 may be formed (S50). Forming the second source/drain regions SD2 may include injecting impurities into the active patterns ACT exposed by the openings 35 by performing a semiconductor process such as a Gas-Phase Doping process (GPD). By forming the second source/drain regions SD2, a channel region CH defined between the first source/drain region SD1 and the second source/drain region SD2 may be formed, in each of the active patterns ACT. Accordingly, each of the active patterns ACT may include the first source/drain region SD1, the channel region CH, and the second source/drain region SD2, sequentially arranged in the first horizontal direction (X-direction).

Metal-semiconductor compound layers 40 may be formed (S60). The metal-semiconductor compound layers 40 may be formed by reacting a metal element with a semiconductor element of end portions of the active patterns ACT exposed by the openings 35. The metal-semiconductor compound layers 40 may form an ohmic contact with the second source/drain regions SD2 of the active patterns ACT exposed by the openings 35. The metal-semiconductor compound layers 40 may be formed of metal silicide. For example, the metal-semiconductor compound layers 40 may include at least one of TiSi, MoSi, ZrSi, and CoSi.

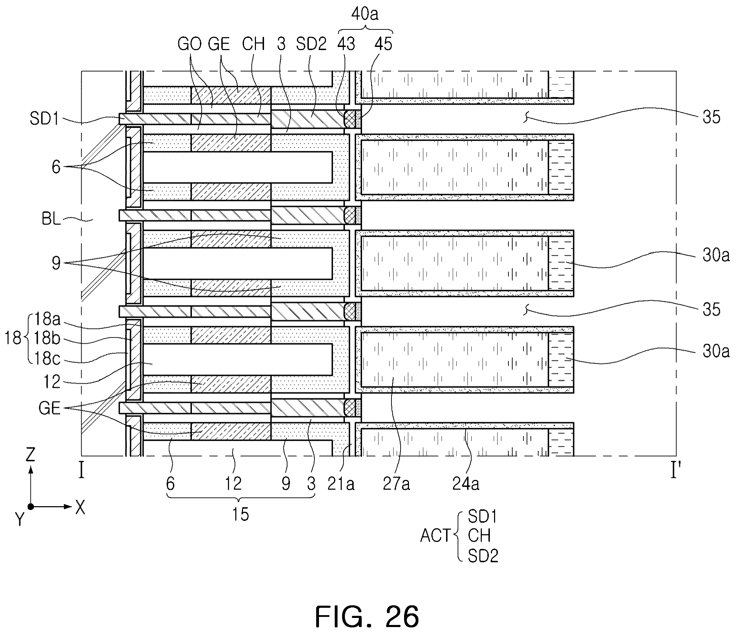

Referring to FIG. 18 and FIG. 26, a nitridation process may be performed to nitridize the metal-semiconductor compound layers 40 (see FIG. 24), thus forming nitrided conductive regions 45 (S70). Accordingly, by the nitriding process, each of the metal-semiconductor compound layers 40 (see FIG. 24) may be formed into a conductive pattern 40a including a remaining metal-semiconductor compound region 43 and a nitrided conductive region 45. Exposed surfaces of the insulating patterns 24a, 27a and 30a and an exposed surface of the buffer insulating layer 21a may be nitrided by the nitriding process.

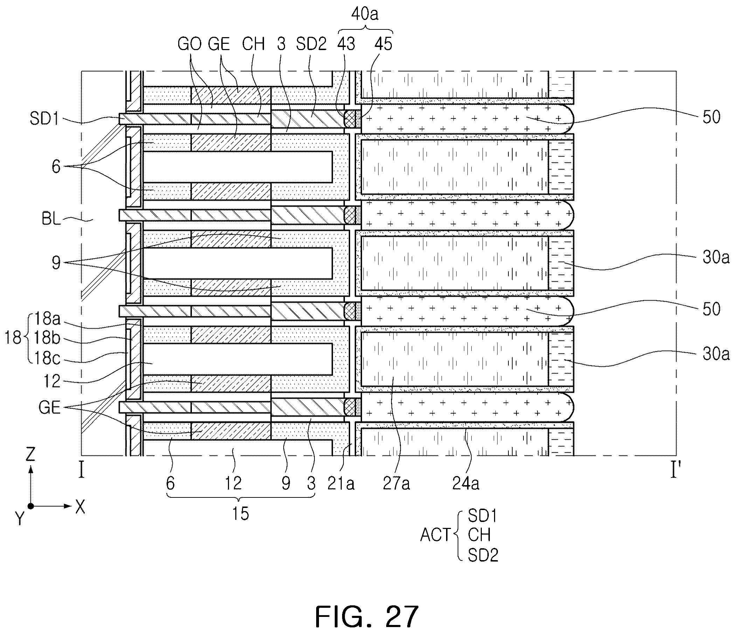

Referring to FIG. 18 and FIG. 27, conductive pillars 50 grown from the nitrided conductive regions 45 may be formed (S80). The conductive pillars 50 may be formed using a metal growth process using a precursor including a metal element. The conductive pillars 50 may be formed of molybdenum (Mo) or tungsten (W). For example, for forming the conductive pillars 50 using molybdenum (Mo), molybdenum may be selectively deposited and formed only on the nitrided conductive regions 45 using a precursor such as MoCl₅, and molybdenum may be formed in a shape of growing from the nitrided conductive regions 45 without depositing molybdenum on the exposed surfaces of the insulating patterns 24a, 27a and 30a and the exposed surface of the buffer insulating layer 21a. Accordingly, the conductive pillars 50 may be formed by growing from the nitrided conductive regions 45.

Each of the conductive pillars 50 may include at least one grain grown from a corresponding nitrided conductive region among the nitrided conductive regions 45. For example, each of the conductive pillars 50 may be formed as a single grain, or may be formed to include grains 50a1, 50a2 and 50a3 as in FIG. 6A or grains 50b1, 50b2 and 50b3 as in FIG. 6B. Each of the conductive pillars 50 may have a convex side surface in a direction away from a corresponding active pattern among the active patterns ACT, for example, in the first horizontal direction (X-direction) (e.g., may have a side surface convex in a direction away from the corresponding active pattern, for example, in the first horizontal direction (X-direction)).

The conductive pillars 50 are formed in a shape grown from the nitrided conductive regions 45, so that each of the conductive pillars 50 may be formed without a seam that may cause defects inside.

The conductive pillars 50 formed in a shape grown from the nitrided conductive regions 45 may be formed within each of the openings 35 (see FIG. 26), thus omitting the node separation process for separating the conductive pillars 50 from each other. Accordingly, the productivity of the semiconductor device may be improved.

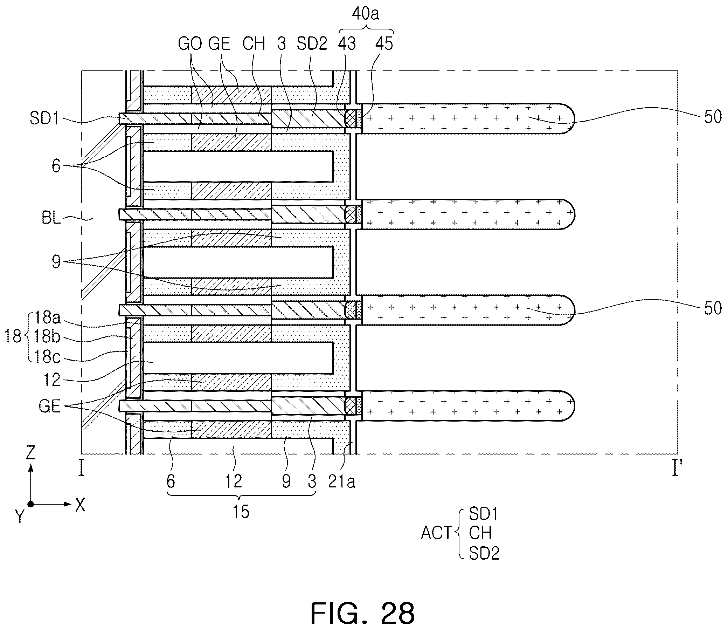

Referring to FIGS. 18 and 28, the insulating patterns 24a, 27a and 30a (see FIG. 26) may be etched to expose the conductive pillars 50. According to an example embodiment, portions of the insulating pattern 24a, 27a, 30a (see FIG. 26) may remain to form the insulating support pattern 28 (see FIGS. 9A and 9B). The insulating support pattern 28 (see FIGS. 9A and 9B) remaining in this manner may prevent the conductive pillars 50 from collapsing or deforming.

Referring again to FIG. 18 along with FIGS. 4, 5A, and 5B, a dielectric layer 55 and an electrode pattern 60 may be formed (S90). The dielectric layer 55 may conformally cover the exposed surface of the conductive pillars 50. The electrode pattern 60 may include a first conductive layer 60a covering the dielectric layer 55 and a second conductive layer 60b on the first conductive layer 60a. The conductive pillars 50, the dielectric layer 55, and the electrode pattern 60 may form a data storage structure DS.

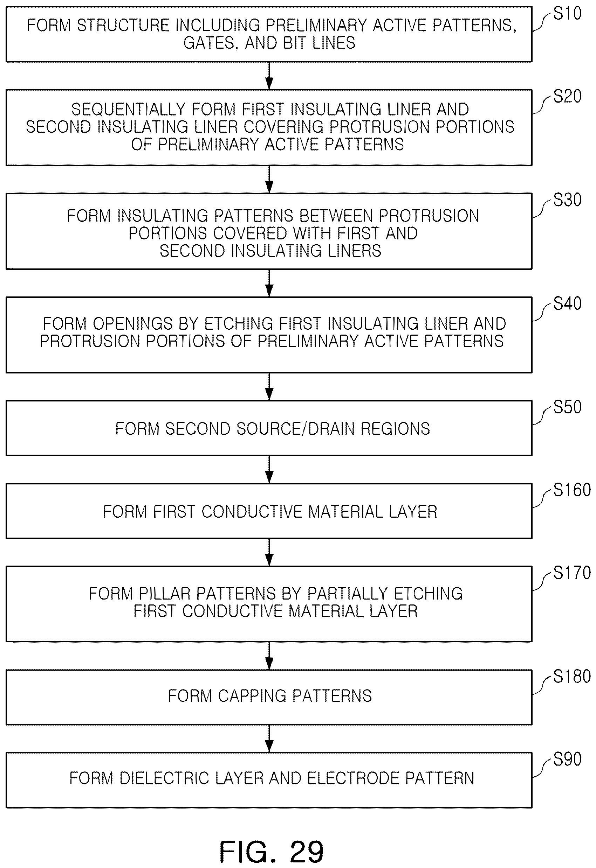

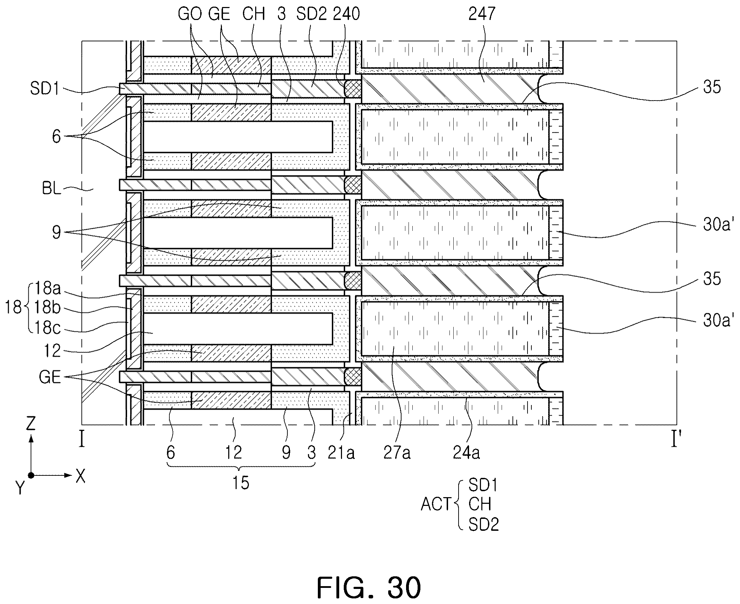

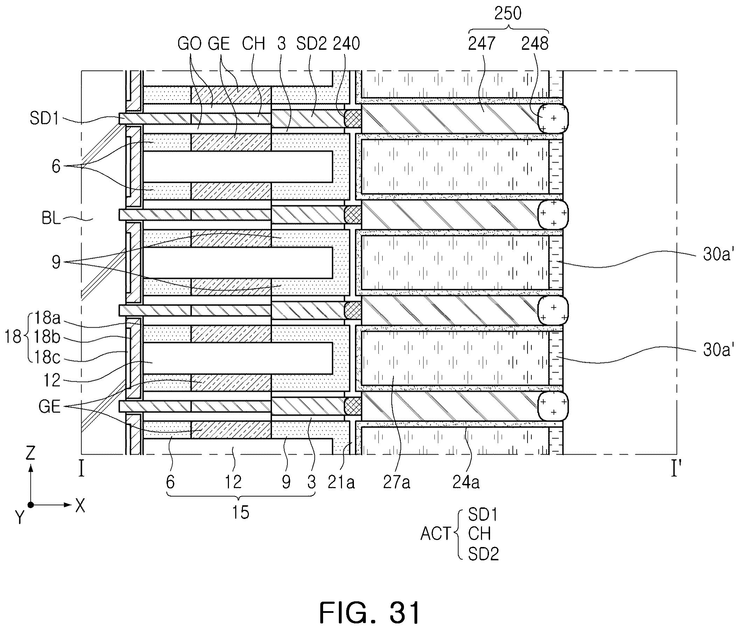

Next, with reference to FIGS. 29 to 31, an example of a method of forming a semiconductor device according to an example embodiment of the present disclosure will be described. In FIGS. 29 to 31, FIG. 29 is a process flow diagram illustrating an example of a method of forming a semiconductor device according to an example embodiment of the present disclosure, and FIGS. 30 and 31 are cross-sectional views illustrating a region corresponding to a region taken along line I-I' of FIG. 4, so as to explain an example of a method of forming a semiconductor device according to an example embodiment of the present disclosure.

Referring to FIGS. 29 and 30, a semiconductor process as described in FIGS. 19 to 25 may be performed. For example, after forming the structure ST described in FIG. 19, a process of forming the openings 35, forming the second source/drain regions SD2, and forming the metal-semiconductor compound layers 40 as described in FIG. 25 may be performed. The metal-semiconductor compound layers 40 may be formed as the conductive patterns 240 (see FIGS. 12A and 12B) described above. The insulating patterns 24a, 27a and 30a including the remaining insulating liner 24a, the mask pattern 30a, and the partially etched insulating layer 27a described in FIG. 25 may be modified according to the example embodiment. For example, in the insulating patterns 24a, 27a and 30a, the remaining insulating liner 24a may be omitted, or the mask pattern 30a may be modified into a mask pattern 30a' with a reduced thickness. Alternatively, the insulating patterns 24a, 27a and 30a may be modified into an insulating pattern of a single material.

A first conductive material layer may be formed (S160). The first conductive material layer may be formed as a conductive liner using a deposition process. The first conductive material layer may be partially etched to form pillar patterns 247 (S170). The pillar patterns 247 may partially fill the openings 35. The pillar patterns 247 may be formed as any one of the embodiments described in FIGS. 12A to 15B, for example, the pillar patterns 447 described in FIGS. 15A and 15B.

Referring to FIGS. 29 and 31, capping patterns 248 may be formed (S180). Accordingly, conductive pillars 250 including the pillar patterns 247 and the capping patterns 248 may be formed.

In an example, the capping patterns 248 may be formed using a metal growth process using a precursor containing a metal element. The capping patterns 248 may be formed using molybdenum (Mo) or tungsten (W). For example, for forming the capping patterns 248 using molybdenum (Mo), molybdenum may be selectively deposited and formed only on the pillar patterns 247 using a precursor such as MoCl₅, and molybdenum may be formed in a shape of growing from the pillar patterns 247 without depositing molybdenum on the exposed surfaces of the insulating patterns 24a, 27a and 30a'. Accordingly, the capping patterns 248 may be formed by growing from the pillar patterns 247.

Again, referring to FIG. 29 along with FIG. 4, FIG. 12A, and FIG. 12B, a dielectric layer 55 and an electrode pattern 60 may be formed (S90). The dielectric layer 55 may conformally cover the exposed surface of the conductive pillars 250. The electrode pattern 60 may include a first conductive layer 60a covering the dielectric layer 55 and a second conductive layer 60b on the first conductive layer 60a. The conductive pillars 250, the dielectric layer 55, and the electrode pattern 60 may form a data storage structure DS.

According to example embodiments, provided are transistors stacked in a vertical direction, a bit line electrically connected to a first side of each of the transistors, and a data storage structure electrically connected to a second side of each of the transistors. Accordingly, since the transistors may be stacked in a vertical direction, the degree of integration of the semiconductor device may be increased.

According to example embodiments, the data storage structure may include a conductive pillar extending in a first horizontal direction from the bit line to the data storage structure. The conductive pillar may have a convex side surface in the first horizontal direction (e.g., may have a side surface convex in the first horizontal direction). Since the conductive pillar may be formed in a shape without a seam that may cause defects, the performance of the semiconductor device including the conductive pillar may be improved.

According to example embodiments, the conductive pillar of the data storage structure may include a pillar pattern and a capping pattern sequentially arranged in the first horizontal direction. The capping pattern may be in contact with an end portion of the pillar pattern and may serve as a capping pattern blocking defects from occurring due to the pillar pattern. For example, the capping pattern may prevent a seam within the pillar pattern from being in contact with a dielectric layer of the data storage structure. Accordingly, the performance of a semiconductor device including the conductive pillar may be improved.

According to example embodiments, a conductive pattern may be provided between a source/drain region of the transistor and the conductive pillar. The conductive pattern may include a metal-semiconductor compound region in contact with the source/drain region and a nitrided conductive region in contact with the conductive pillar. The nitrided conductive region may prevent a metal element of the conductive pillar from diffusing into the source/drain region of the transistor.

According to example embodiments, a method of forming a semiconductor device includes: forming an active pattern, a gate adjacent to the active pattern, and a bit line electrically connected to a first end of the active pattern; on a second end of the active pattern opposite to the first end, forming a metal-semiconductor compound layer; nitriding an end portion of the metal-semiconductor compound layer to form a nitrided conductive region; forming a conductive pillar on the nitrided conductive region using a metal growth process using a precursor including a first metal element; forming a dielectric layer over an exposed surface of the conductive pillar; and forming an electrode pattern covering the dielectric layer.

The forming of the metal-semiconductor compound layer may include reacting a second metal element with a semiconductor element of the active pattern.

Advantages and effects of the present disclosure are not limited to the foregoing content and may be more easily understood in the process of describing a specific example embodiment of the present disclosure.

Although example embodiments of the present disclosure have been described with reference to the accompanying drawings, it will be understood by those skilled in the art that the present disclosure may be implemented in other specific forms without changing technical concepts or some features thereof. Therefore, it should be understood that the example embodiments described above are examples and not limitative in all respects.

## Claims

1. A semiconductor device (1), comprising:
transistors (TR) stacked in a vertical direction (Z);
a bit line (BL) electrically connected to a first end of each of the transistors (TR);
and
a data storage structure (DS) electrically connected to a second end of each of the transistors (TR),
wherein the data storage structure (DS) includes:
conductive pillars (50) extending in a first horizontal direction (X);
an electrode pattern (60) covering the conductive pillars (50); and
a dielectric layer (55) between each of the conductive pillars (50) and the electrode pattern (60),
wherein the first horizontal direction (X) is perpendicular to the vertical direction (Z) and is a direction oriented from the bit line (BL) to the data storage structure (DS),
wherein each of the conductive pillars (50) has a first side surface (50_S1) adjacent to a corresponding transistor (TR) among the transistors (TR), and a second side surface (50_S2) opposite to the first side surface (50_S1), and
wherein the second side surface (50_S2) of a first conductive pillar (50) among the conductive pillars (50) has a convex shape.

2. The semiconductor device (1) of claim 1, further comprising:
conductive patterns (40a),
wherein each of the transistors (TR) includes:
a first source/drain region (SD1), a channel region (CH), and a second source/drain region (SD2), sequentially arranged in the first horizontal direction (X);
a gate electrode (GE) vertically overlapping the channel region (CH); and
a gate dielectric layer (GO) between the gate electrode (GE) and the channel region (CH),
wherein the first source/drain regions (SD1) of the transistors (TR) are electrically connected to the bit line (BL),
wherein each of the conductive patterns (40a) is between a corresponding second source/drain region (SD2) of the second source/drain regions (SD2) of the transistors (TR) and a corresponding conductive pillar (50) of the conductive pillars (50), and
wherein each of the conductive patterns (40a) includes a metal-semiconductor compound region (43) in contact with the corresponding second source/drain region (SD2), and a nitrided conductive region (45) in contact with the corresponding conductive pillar (50).

3. The semiconductor device (1) of claim 2,
wherein the metal-semiconductor compound region (43) of each of the conductive patterns (40a) includes a first conductive material, and
wherein the nitrided conductive region (45) of each of the conductive patterns (40a) includes a second conductive material formed by nitriding the first conductive material.

4. The semiconductor device (1) of claim 2 or claim 3,
wherein the first conductive pillar (50) includes:
a first pillar region (150_1) in contact with a corresponding conductive pattern (40a) among the conductive patterns (40a), and
a second pillar region (150_2) extending from the first pillar region (150_1),
and
wherein the second pillar region (150_2) has a thickness in the vertical direction (Z) greater than a thickness of the first pillar region (150_1) in the vertical direction (Z), and
wherein the second pillar region (150_2) has a length in the first horizontal direction (X) greater than a length of the first pillar region (150_1) in the first horizontal direction (X).

5. The semiconductor device (1) of claim 4,
wherein the dielectric layer (55) of the data storage structure (DS) is spaced apart from the first pillar region (150_1) and is in contact with the second pillar region (150_2).

6. The semiconductor device (1) of any of claims 2-5,
wherein a first conductive pattern (140a) among the conductive patterns (140a) corresponds to the first conductive pillar (50) and extends into the first conductive pillar (50) in the first horizontal direction (X), and
wherein, in the first conductive pattern (140a), a portion of the first conductive pattern (140a) extending into the first conductive pillar (50) has an upper surface, a lower surface, and a side surface in contact with the first conductive pillar (50).

7. The semiconductor device (1) of any preceding claim, further comprising:
an insulating support pattern (28),
wherein each conductive pillar (50) of the conductive pillars (50) includes:
a first horizontal region (50_1a) in which upper and lower surfaces of the conductive pillar (50) are in contact with the insulating support pattern (28); and
a second horizontal region (50_2a) extending from the first horizontal region (50_1a) in the first horizontal direction (X) in which the upper and lower surfaces of the conductive pillar (50) are covered with the dielectric layer (55) and the electrode pattern (60), and
wherein, in each of the conductive pillars (50), a length of the second horizontal region (50_2a) in the first horizontal direction (X) is greater than a length of the first horizontal region (50_1a) in the first horizontal direction (X).

8. The semiconductor device (1) of any preceding claim,
wherein the first conductive pillar (50) includes at least one grain (50a1, 50a2, 50a3), the grain having a length in the first horizontal direction (X) greater than a thickness (Z) of the first conductive pillar (50) in the vertical direction (Z).

9. The semiconductor device (1) of any preceding claim,
wherein the first conductive pillar (50) includes a pillar pattern (247) and a capping pattern (248) in contact with the pillar pattern (247),
wherein a side surface of the pillar pattern (247) is the first side surface (50_S1) of the first conductive pillar (50), and
wherein a side surface of the capping pattern (248) is the second side surface (50_S2) of the first conductive pillar (50).

10. The semiconductor device (1) of claim 9,
wherein a maximum length of the pillar pattern (247) in the first horizontal direction (X) is greater than a maximum length of the capping pattern (248) in the first horizontal direction (X).

11. The semiconductor device (1) of claim 9 or claim 10,
wherein a maximum length of the pillar pattern (247) in the first horizontal direction (X) is greater than a thickness of the pillar pattern (247) in the vertical direction (Z).

12. The semiconductor device (1) of any preceding claim,
wherein the first conductive pillar (50) includes a first grain (50a1) extending from a lower surface of the first conductive pillar (50) to an upper surface of the first conductive pillar (50).

13. The semiconductor device (1) according to claim 12,
wherein the first grain (50a1) of the first conductive pillar (50) has a length in the first horizontal direction (X) greater than a thickness of the first conductive pillar (50) in the vertical direction (Z).

14. The semiconductor device (1) according to claim 12 or claim 13,
wherein the first conductive pillar (50) further includes a second grain (50a2) extending from one of the lower surface and the upper surface of the first conductive pillar (50) toward the other of the lower surface and the upper surface of the first conductive pillar, the second grain (50a2) having a length in the first horizontal direction (X) greater than a thickness of the first conductive pillar (50) in the vertical direction (Z).
